# EUROPÄISCHE PATENTANMELDUNG

(11) **EP 0 933 972 A2**
(43) Veröffentlichungstag der Anmeldung: **04.08.1999**
(21) Anmeldenummer: 99100777.4
(22) Anmeldetag: 16.01.1999
(51) Int. Cl.: H05B 33/14, C09K 11/06, H01L 51/20

(54) **Elektrolumineszierende Anordnung unter Verwendung von dotierten Blendsystemen**

(30) Priorität: 31.01.1998 DE 19803889
(71) Anmelder: BAYER AG, 51368 Leverkusen (DE); ROBERT BOSCH GmbH, 70469 Stuttgart (DE)
(72) Erfinder: Heuer, Helmut-Werner Dr., 47829 Krefeld (DE); Wehrmann, Rolf Dr., 47800 Krefeld (DE); Deussen, Martin Dr., 35039 Marburg (DE); Elschner, Andreas Dr., 45479 Mülheim (DE); Hüppauff, Martin Dr., 70563 Stuttgart (DE)
(74) Vertreter: Zobel, Manfred, Dr.

(57) **Zusammenfassung**

Elektrolumineszierende Anordnungen, aufgebaut aus einem Substrat, einer Anode, einem elektrolumineszierenden Element und einer Kathode, wobei wenigstens eine der beiden Elektroden im sichtbaren Spektralbereich transparent ist und das elektrolumineszierende Element folgende Zonen enthalten kann: eine lochinjizierende Zone, lochtransportierende Zone, elektrolumineszierende Zone, elektronentransportierende Zone und/oder eine elektroneninjizierende Zone, dadurch gekennzeichnet, daß die lochinjizierende und/oder lochtransportierende Zone eine gegebenenfalls substituierte Tris-1,3,5-(aminophenyl)benzolverbindung A) oder eine Mischung davon enthält, das elektrolumineszierende Element gegebenenfalls eine weitere funktionalisierte Verbindung aus der Gruppe der gegebenenfalls lochtransportierenden Materialien, ein lumineszierendes Material B), ein Chinacridon-Derivat C), wobei die lochinjizierende und lochtransportierende Zone neben der Komponente A eine oder mehrere weitere lochtransportierende Verbindungen enthalten kann, wobei mindestens eine Zone vorhanden ist, einzelne Zonen weggelassen werden können und die vorhandene(n) Zone(n) mehrere Aufgaben übernehmen kann.

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-A 4 539 507, US-A 4 769 262, US-A 5 077 142, EP-A 406 762, EP-A 278 758, EP-A 278 757).

Weiterhin werden Polymere, wie Poly-(p-phenylene) und Poly-(p-phenylenvinylenc) (PPV) als elektrolumineszierende Polymere beschrieben: G. Leising et al., Adv. Mater. 4 (1992) No. 1; Friend et al., J. Chem. Soc., Chem Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 443 861, WO-A 92/03490 und WO-A 92/03491 beschrieben.

EP-A 0 294 061 stellt einen optischen Modulator auf Basis von Polyacetylen vor.

Zur Herstellung flexibler Polymer-LEDs haben Heeger at al. lösliche konjugierte PPV-Derivate vorgeschlagen (WO-A 92/16023).

Polymerblends unterschiedlicher Zusammensetzung sind ebenfalls bekannt: M. Stolka et al., Pure & Appl. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
1 Träger, Substrat
2 Basiselektrode
3 Löcher-injizierende Schicht
4 Löcher-transportierende Schicht
5 Licht-emittierende Schicht
6 Elektronen-transportierende Schicht
7 Elektronen-injizierende Schicht
8 Topelektrode
9 Kontakte
10 Umhüllung, Verkapselung.

Die Schichten 3 bis 7 stellen das elektrolumineszierende Element dar.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO-A 90/13148 auf der Basis von Poly-(p-phenylenvinylen) beschrieben.

Tang et al. beschreiben, daß die Effizienz von Elektrolumineszenz-Anordnungen dadurch verbessert werden kann, daß eine Emitterschicht verwendet wird, die aus organischem Matrixmaterial besteht, der eine kleine Menge eines Dotierungsstoffes zugemischt ist (US-A 4 769 292). Bevorzugtes Material ist dabei Aluminium-8-hydroxychinolin (Alq₃). Die Dotierungsstoffe können aus einer Reihe von verschiedenen Klassen von intensiv fluoreszierenden Stoffen ausgewählt werden. Bevorzugte Beispiele hierfür sind Cumarine und Rhodamine.

Murayama et al. beschreiben unlösliche Chinacridon-Pigmente als Dotierungsstoffe (US-A 5 227 252). Weiterhin werden substituierte, aber unlösliche Chinacridon-Pigmente beschrieben, die alle durch Aufdampfverfahren zusammen mit der elektrolumineszierenden Komponente (meist Alq₃) aufgebracht werden (Co-Verdampfung) EP-A 0 766 498 und Tang, Information Display 10/96, C.W. Tang, Information Display 10/96, 16 (1996), T. Wakimoto, S. Kawami, K. Nagayama, Y. Yonemoto, R. Murayama, J. Funaki, H. Sato, H. Nakada, K. Imai, International Symposium of Inorganic and Organic Electroluminescence 1994, Hamamatsu, Japan 1994, Tagungsband S. 77, J. Shi, C.W. Tang, Appl. Phys. Lett. 70 (13), 1665 (1997), US-A 5 616 427. Dabei wurde festgestellt, daß EL-Anordnungen mit Dotierungsstoff in der organischen Emitterschicht außer einer erhöhten Effizienz auch ein verbessertes Langzeitverhalten beim Betrieb aufweisen.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings kann der Anlöseprozeß einer bereits aufgebrachten Schicht beim Überschichten mit der nächsten Schicht in bestimmten Fällen eine Schwierigkeit darstellen.

Die Aufgabe der vorliegenden Erfindung ist die Bereitstellung von elektrolumineszierenden Anordnungen mit hoher Leuchtdichte und verbesserter Stabilität, wobei die aufzubringende, dotierte Mischung gießbar aufgebracht werden kann.

Dazu war es erforderlich, speziell substituierte Chinacridon-Derivate zu synthetisieren, die in den verwendeten Lösungsmitteln für den Gießprozeß eine ausreichende Löslichkeit aufweisen. Gegossene, dotierte Systeme sollten dabei gegenüber undotierten Systemen ein verbessertes Langzeitverhalten zeigen.

Es wurde gefunden, daß elektrolumineszierende Anordnungen, die untengenanntes Blendsystem enthalten, diese Anforderungen erfüllen. Im folgenden ist der Begriff Zone auch mit Schicht gleichzusetzen.

Gegenstand der vorliegenden Erfindung sind daher elektrolumineszierende An-ordnungen, enthaltend ein Substrat, eine Anode, ein elektrolumineszierendes Element und eine Kathode, wobei wenigstens eine der beiden Elektroden im sichtbaren Spektralbereich transparent ist und das elektrolumineszierende Element der Reihe nach enthalten kann:

Eine lochinjizierende Zone, lochtransportierende Zone, elektrolumineszierende Zone, elektronentransportierende Zone und/oder eine elektroneninjizierende Zone, dadurch gekennzeichnet, daß die lochinjizierende und/oder lochtransportierende Zone eine gegebenenfalls substituierte Tris-1,3,5-(aminophenyl)benzolverbindung A oder eine Mischung davon ist und das elektrolumineszierende Element gegebenenfalls eine weitere funktionalisierte Verbindung aus der Gruppe der lochtransportierenden Materialien, ein lumineszierendes Material B und gegebenenfalls Elektronentransportmaterialien enthält, wobei die lochinjizierende und lochtransportierende Zone neben der Komponente A eine oder mehrere weitere lochtransportierende Verbindungen enthalten kann, wobei mindestens eine Zone vorhanden ist, einzelne Zonen weggelassen werden können und die vorhandene(n) Zone(n) mehrere Aufgaben übernehmen kann, wobei das elektrolumineszierende Element in mindestens einer Zone eine substituierte Chinacridon-Verbindung C als Dotierstoff enthält.

Eine Zone kann mehrere Aufgaben übernehmen, d.h. daß eine Zone z.B. lochinjizierende, lochtransportierende, elektrolumineszierende, elektroneninjizierende und/oder elektronentransportierende Substanzen sowie Dotierstoff enthalten kann.

Das elektrolumineszierende Element kann ferner einen oder mehrere transparente polymere Binder D enthalten.

Die gegebenenfalls substituierte Tris-1,3,5-(aminophenyl)benzol-Verbindung A steht für eine aromatische tertiäre Aminoverbindung der allgemeinen Formel (I) 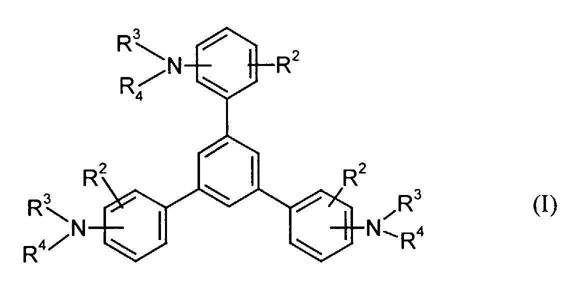 in welcher
- R²: für Wasserstoff, gegebenenfalls substituiertes Alkyl oder Halogen steht,
- R³ und R⁴: unabhängig voneinander für gegebenenfalls substituiertes C₁-C₁₀-Alkyl, Alkoxycarbonyl-substituiertes C₁-C₁₀-Alkyl, jeweils gegebenenfalls substituiertes Aryl, Aralkyl oder Cycloalkyl stehen.
- R³ und R⁴: stehen unabhängig voneinander bevorzugt für C₁-C₆-Alkyl, insbesondere Methyl, Ethyl, n- oder iso-Propyl, n-, iso-, sec.- oder tert.-Butyl, C₁-C₄-Alkoxcarbonyl-C₁-C₆-alkyl, wie beispielsweise Methoxy-, Ethoxy-, Propoxy-, Butoxycarbonyl-C₁-C₄-alkyl, jeweils gegebenenfalls durch C₁-C₄-Alkyl und/oder C₁-C₄-Alkoxy substituiertes Phenyl-C₁-C₄-alkyl, Naphthyl-C₁-C₄-alkyl, Cyclopentyl, Cyclohexyl, Phenyl oder Naphthyl.

Besonders bevorzugt stehen R³ und R⁴ unabhängig voneinander für unsubstituiertes Phenyl oder Naphthyl oder jeweils einfach bis dreifach durch Methyl, Ethyl, n-, iso-Propyl, Methoxy, Ethoxy, n- und/oder iso-Propoxy substituiertes Phenyl oder Naphthyl.

R² steht vorzugsweise für Wasserstoff, C₁-C₆-Alkyl, wie beispielsweise Methyl, Ethyl, n-oder iso-Propyl, n-, iso-, sec.- oder tert.-Butyl, oder Chlor.

Derartige Verbindungen und deren Herstellung sind in US-P 4 923 774 für den Einsatz in der Elektrophotographie beschrieben, welches hiermit ausdrücklich als Bestandteil der Beschreibung aufgenommen wird ( 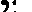 incorporated by reference"). Die Tris-Nitrophenyl-Verbindung kann beispielsweise durch allgemein bekannte katalytische Hydrierung beispielsweise in Gegenwart von Raney-Nickel in die Tris-aminophenyl-Verbindung überführt werden (Houben-Weyl 4/1C, 14-102, Ullmann (4), 13, 135-148). Die Aminoverbindung wird in allgemein bekannter Weise mit substituierten Halogenbenzolen umgesetzt.

Beispielhaft seien die folgenden Verbindungen genannt, wobei die Substitution am Phenylring ortho, meta und/oder para zum Aminstickstoff erfolgen kann:

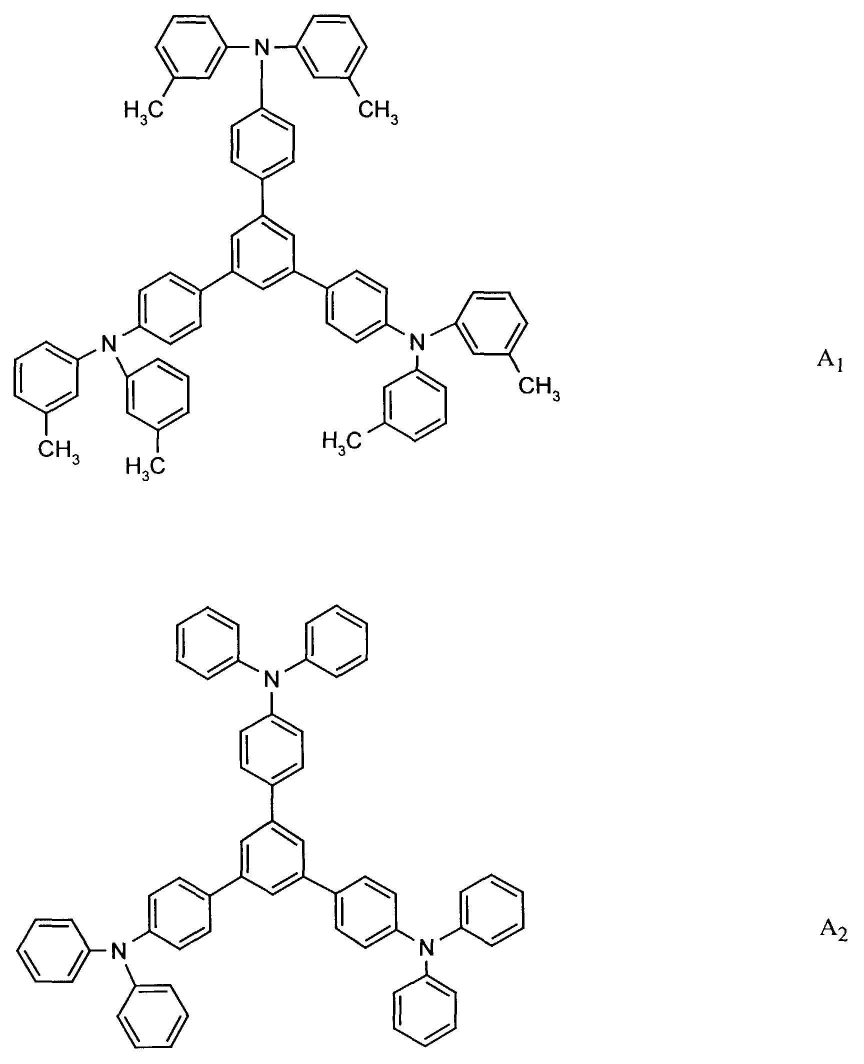

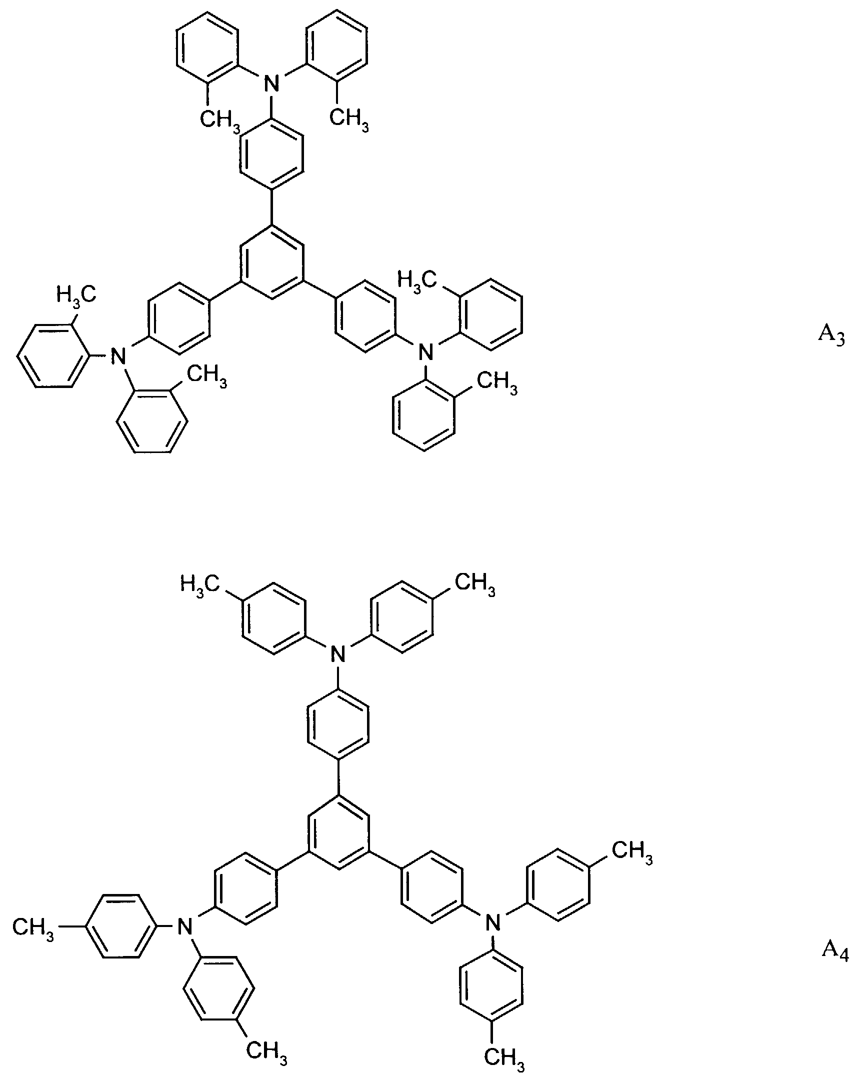

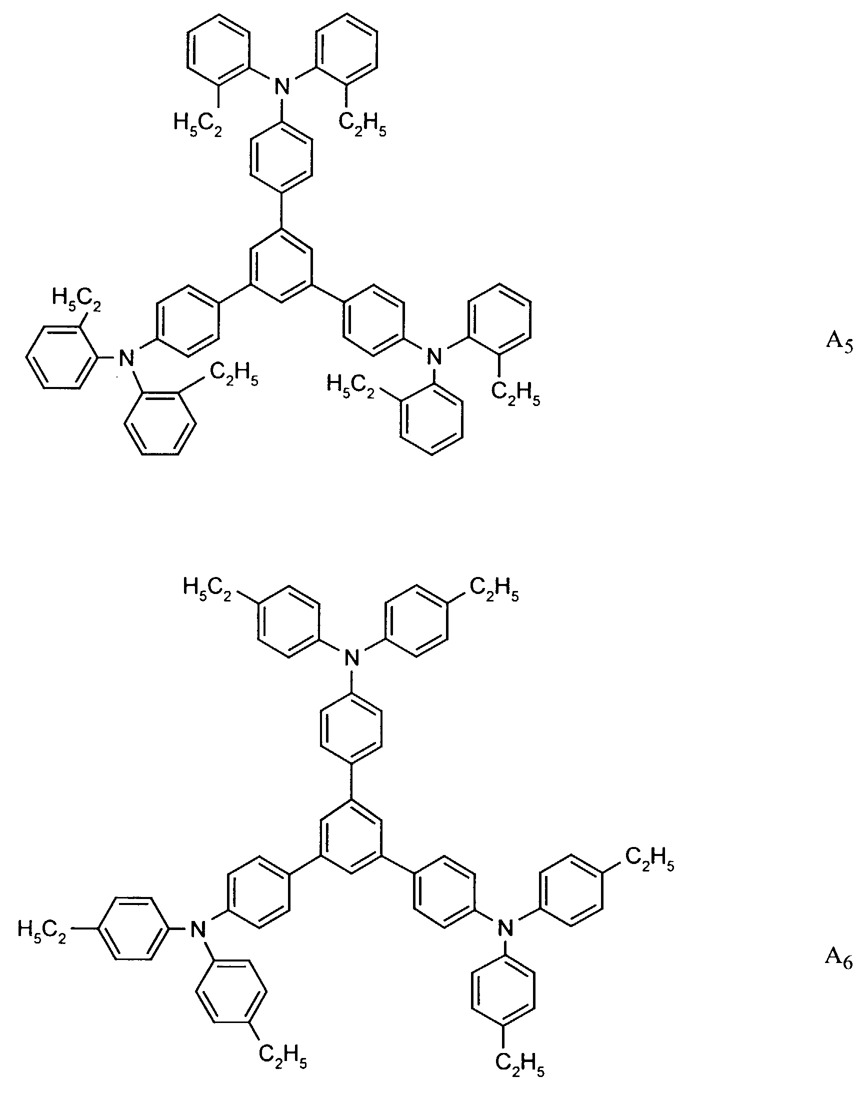

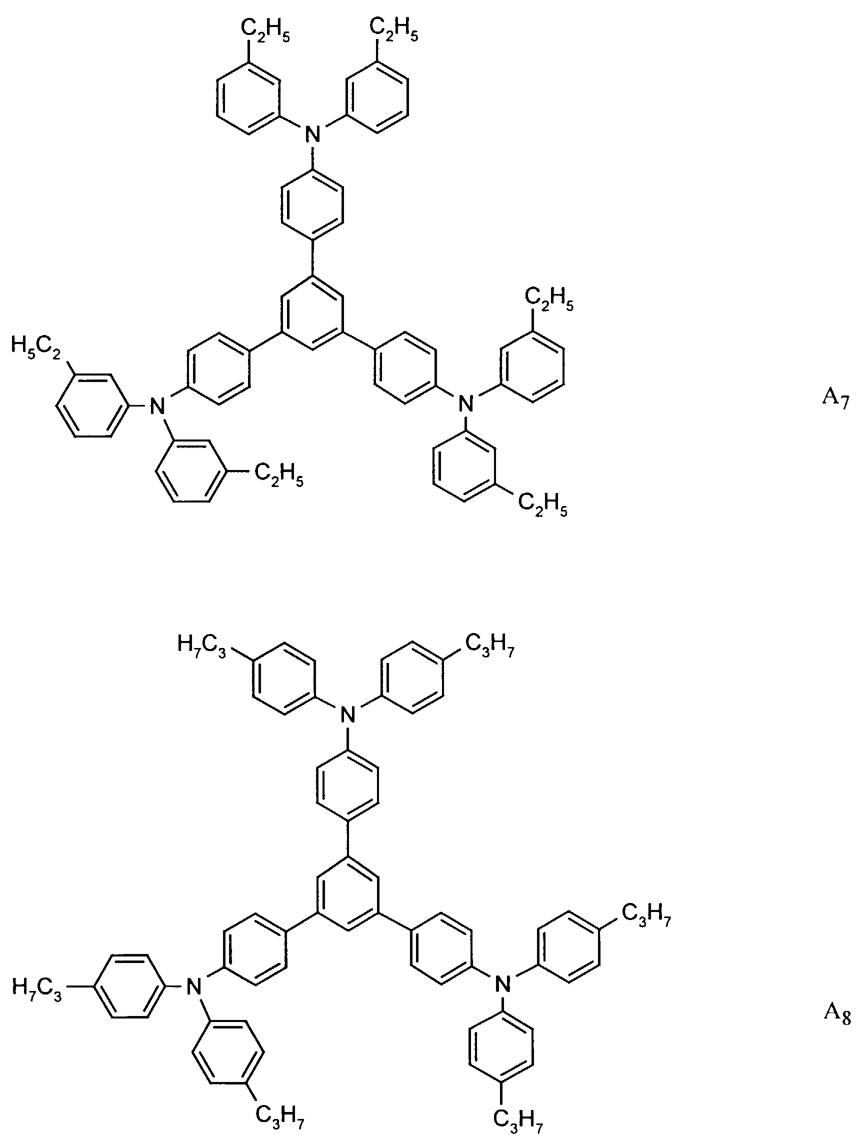

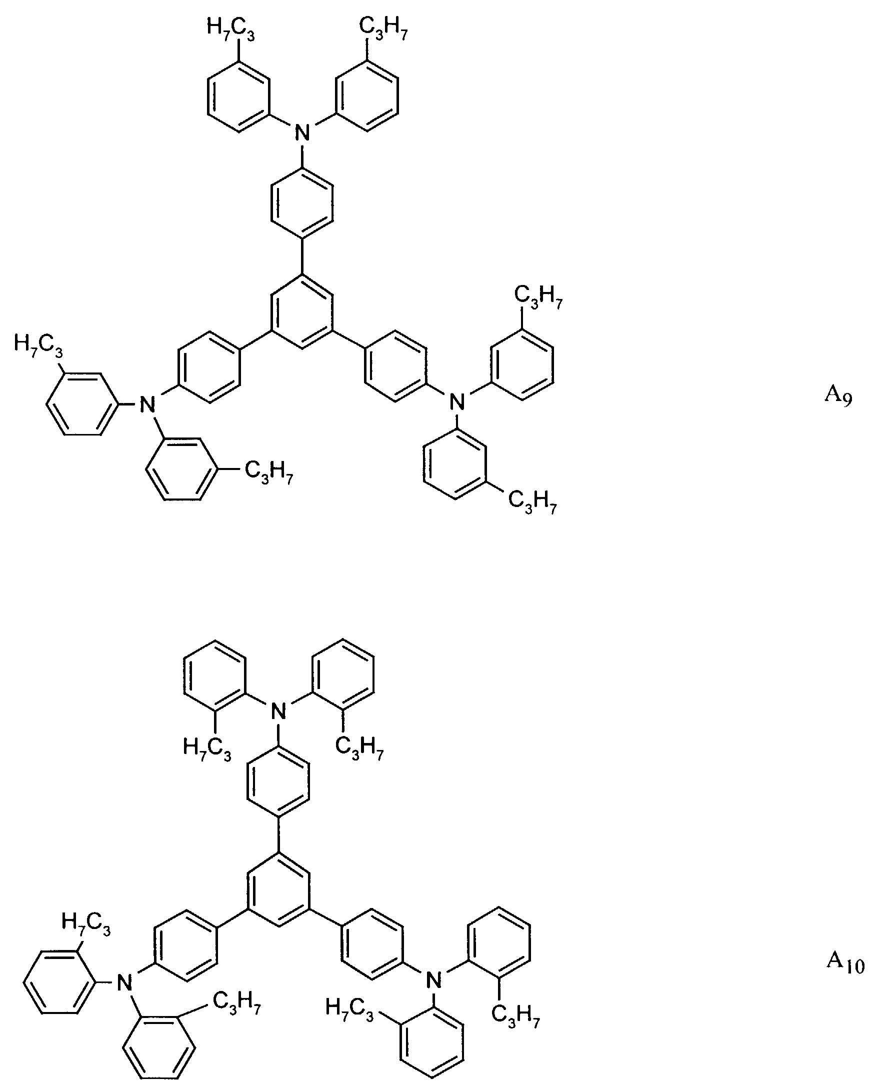

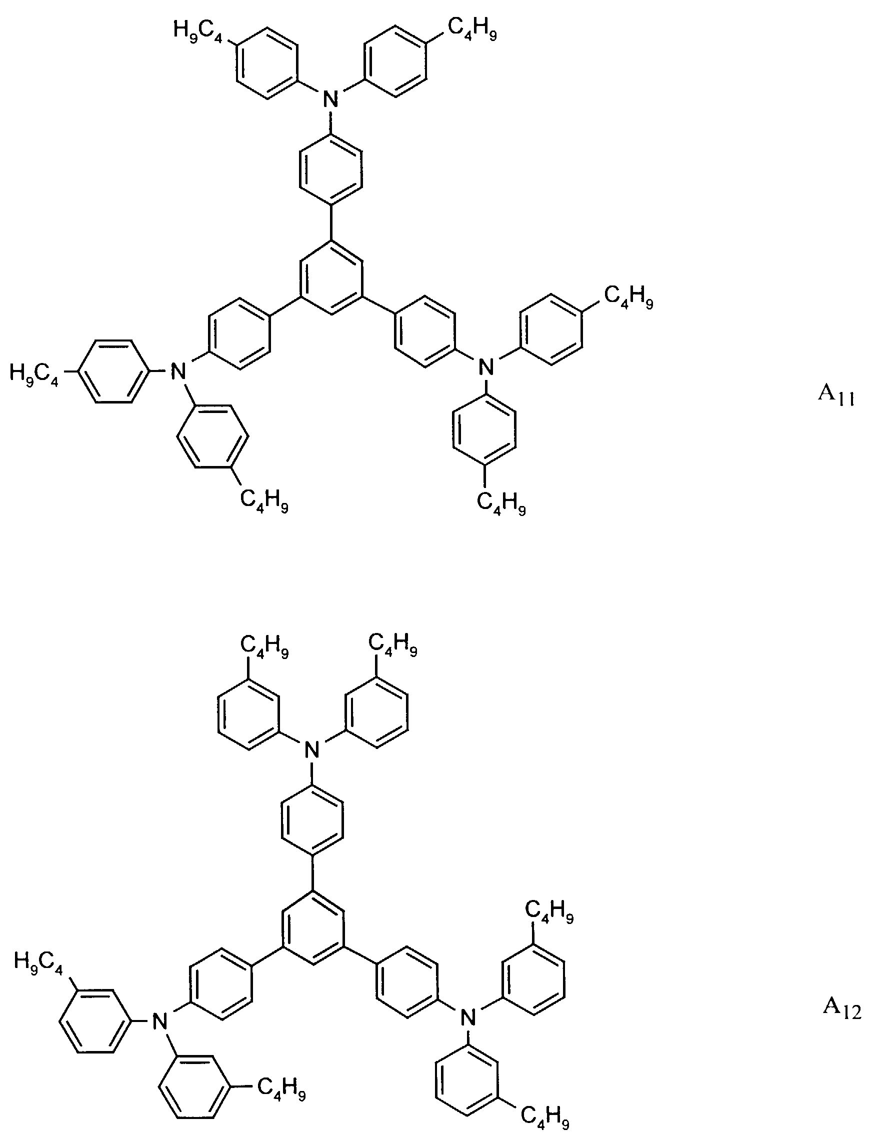

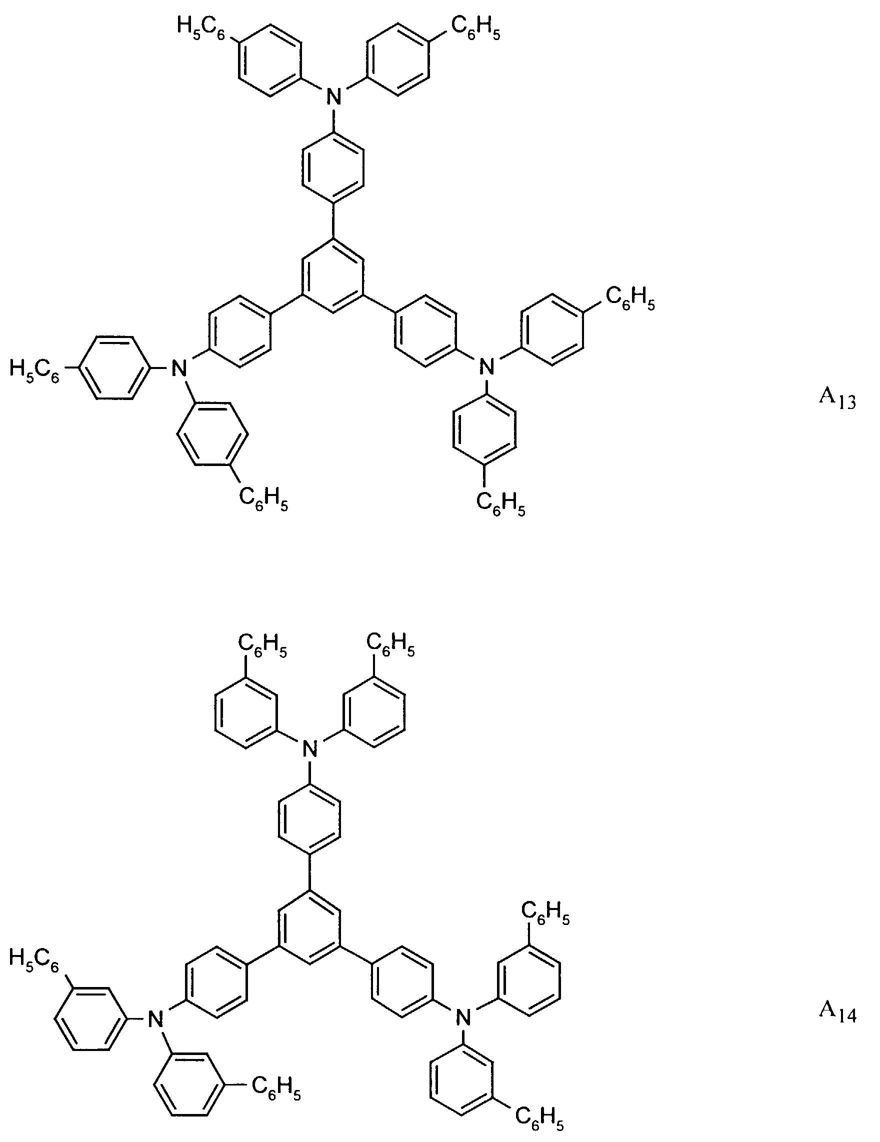

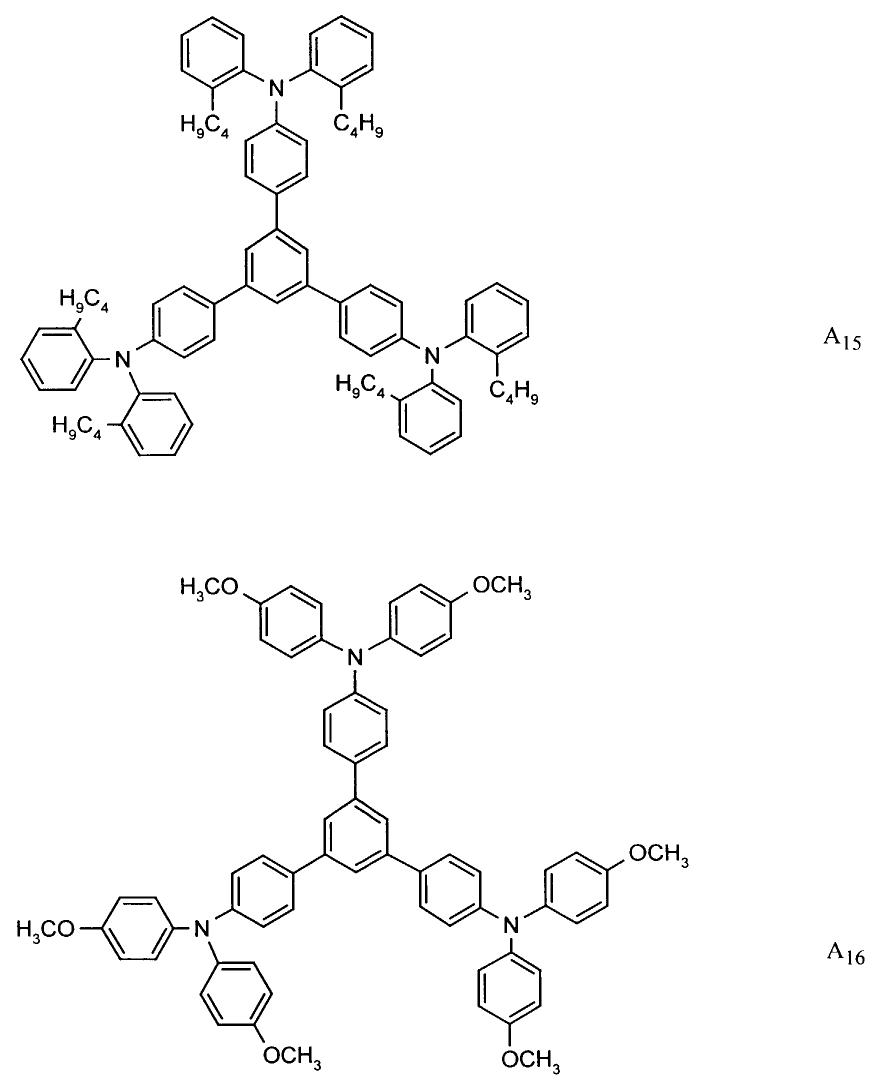

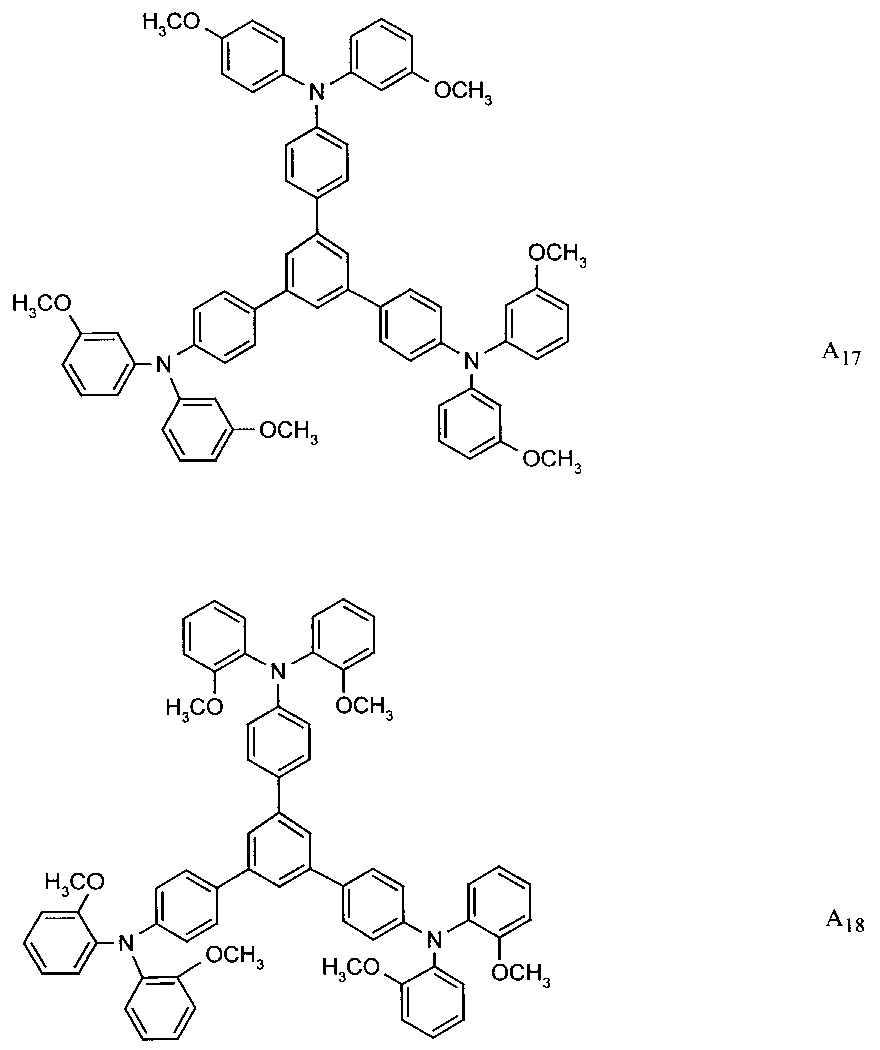

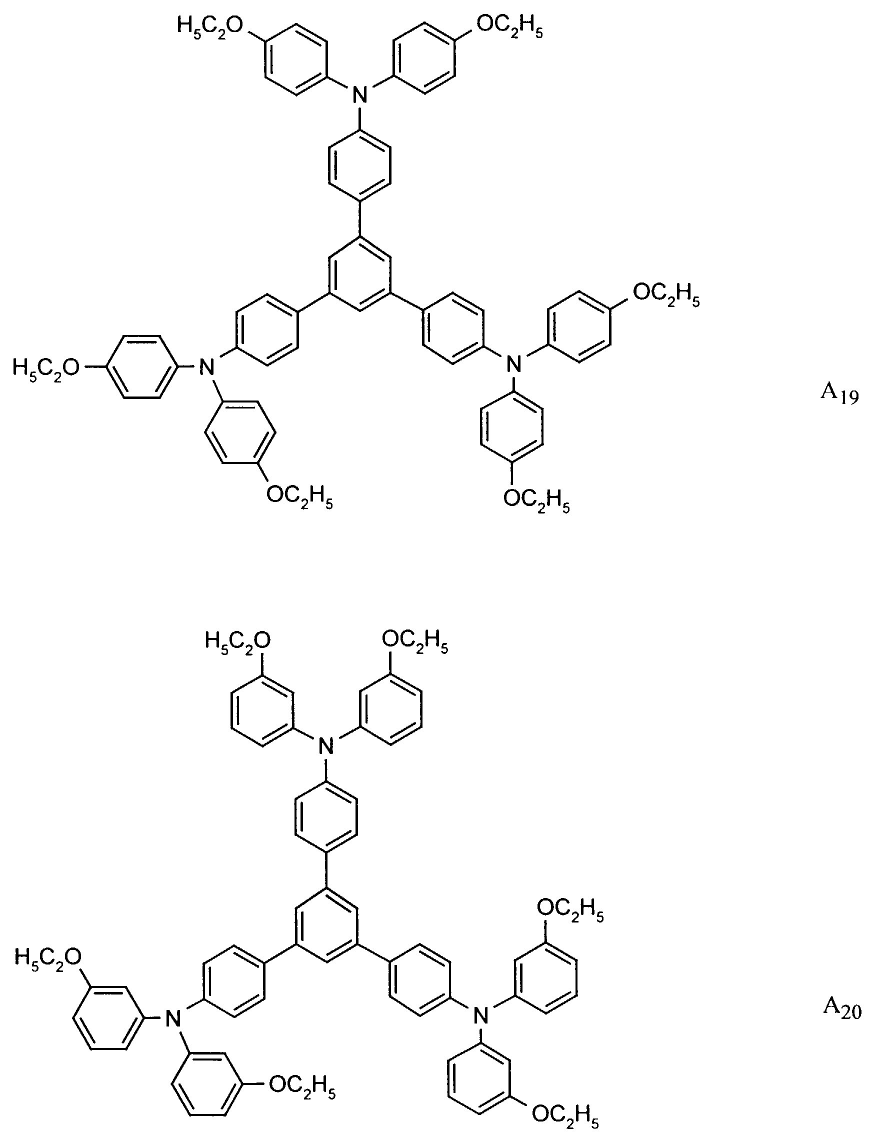

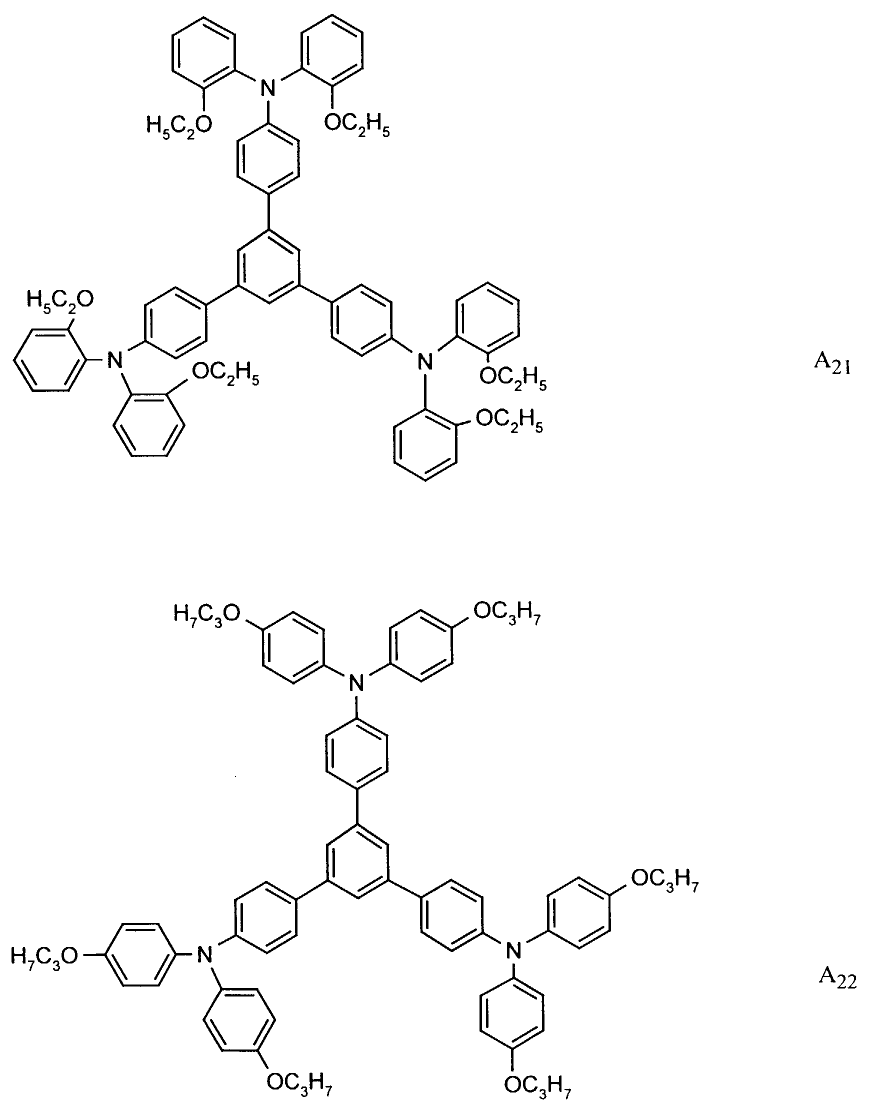

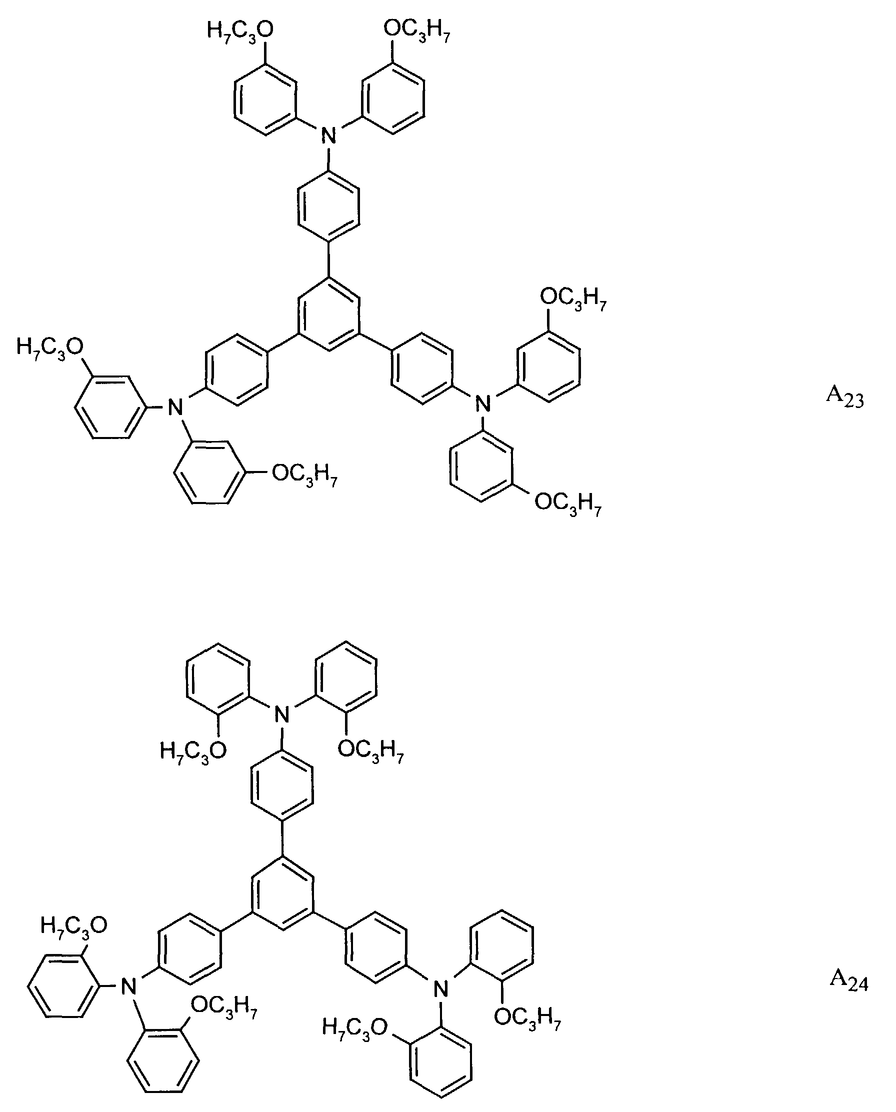

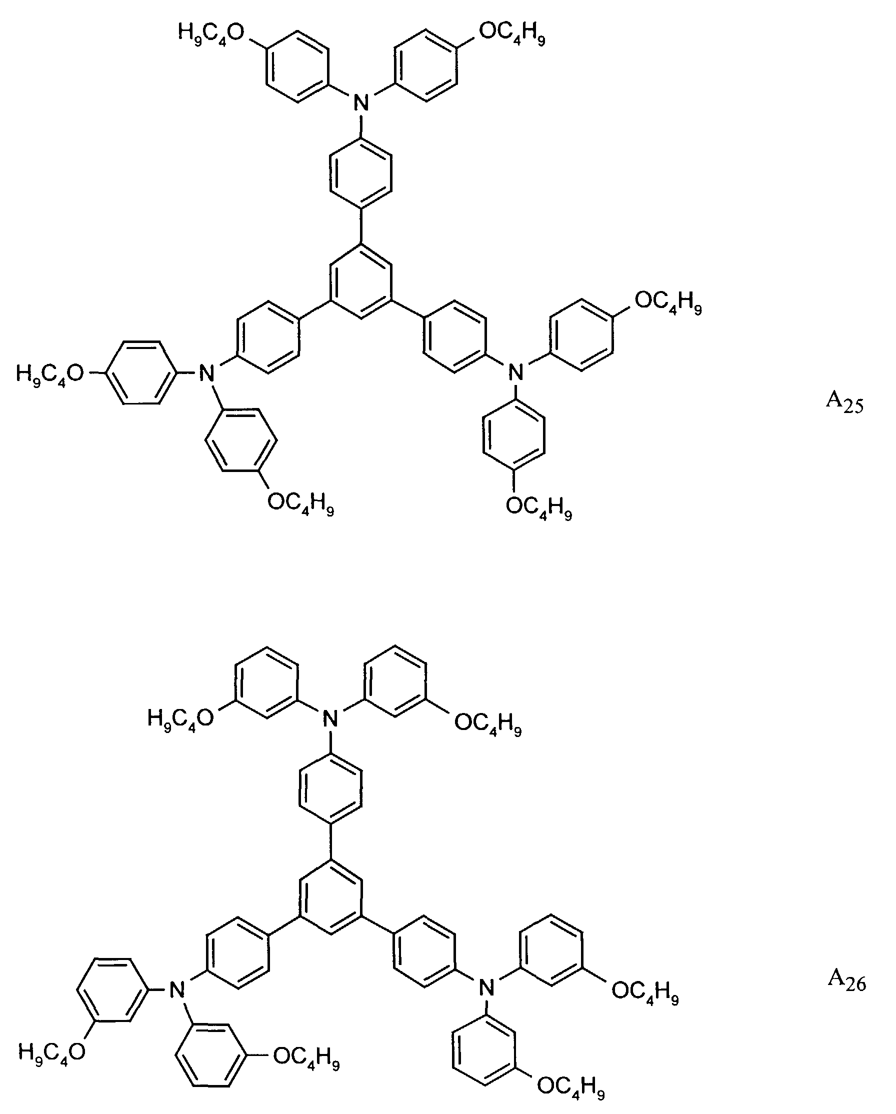

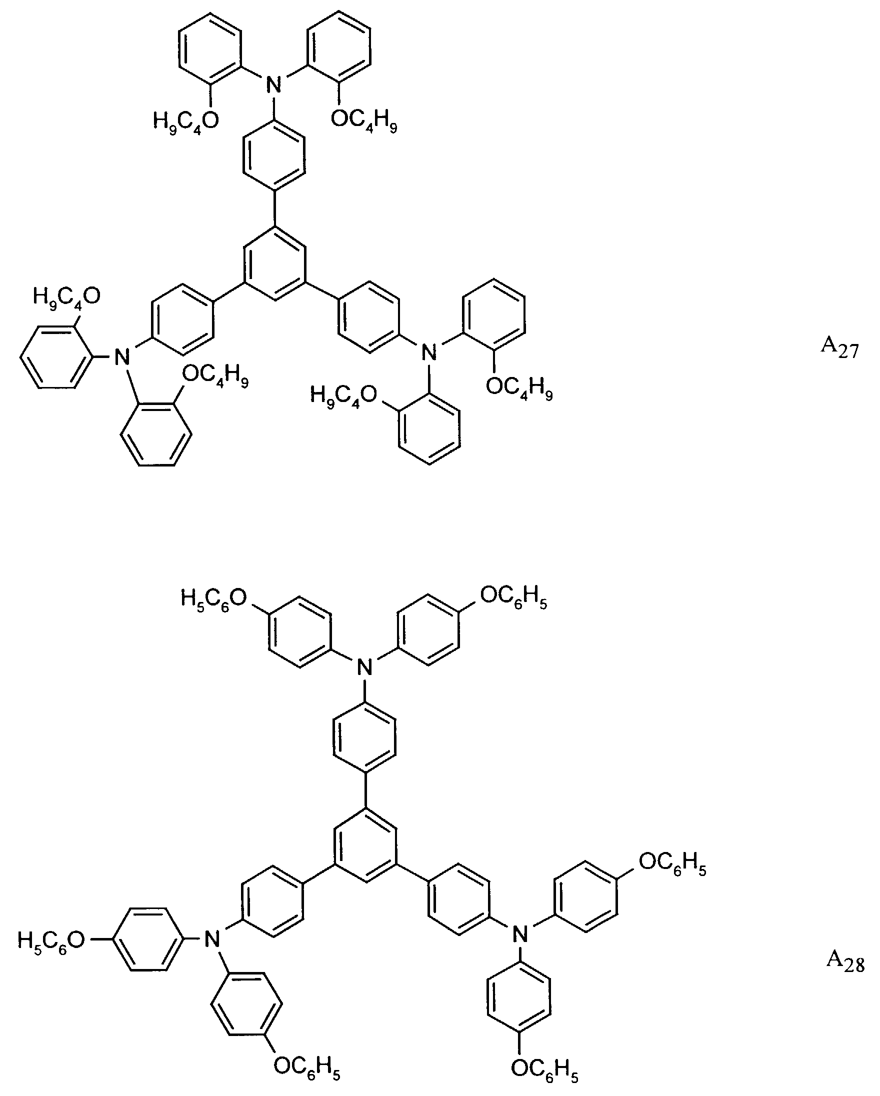

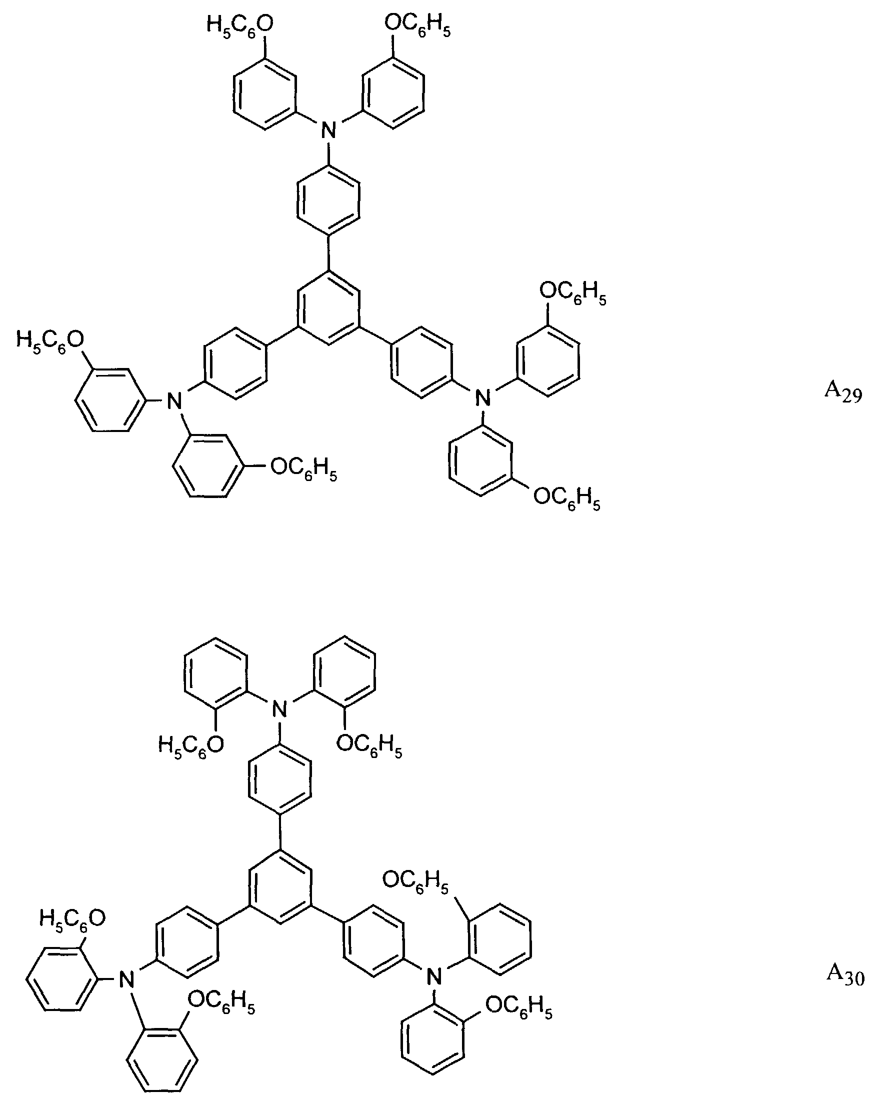

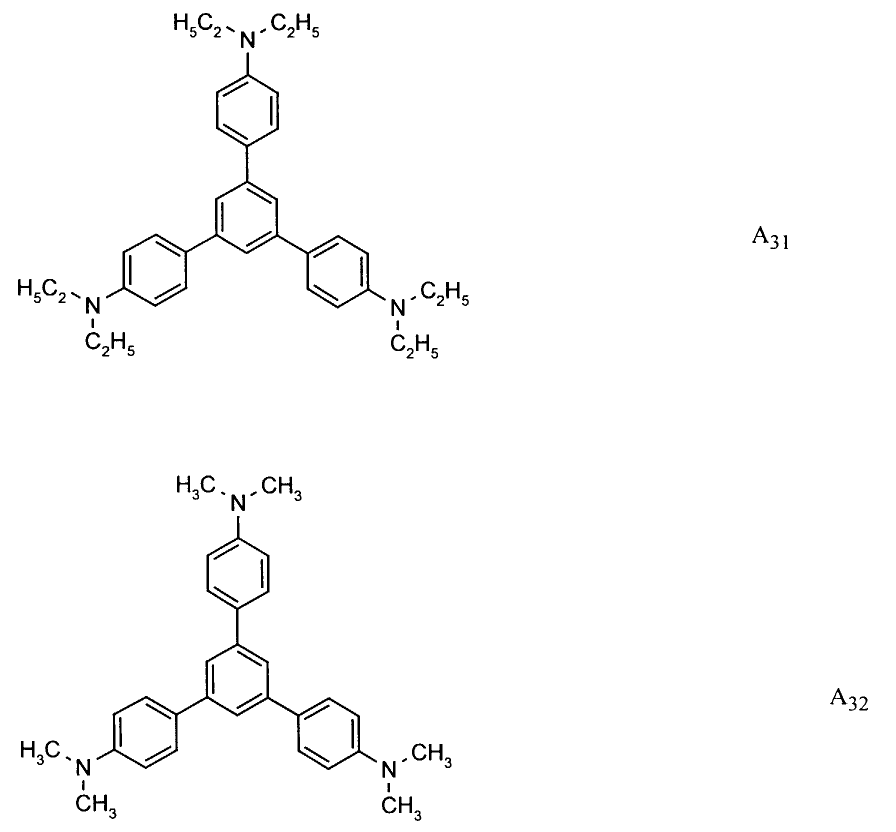

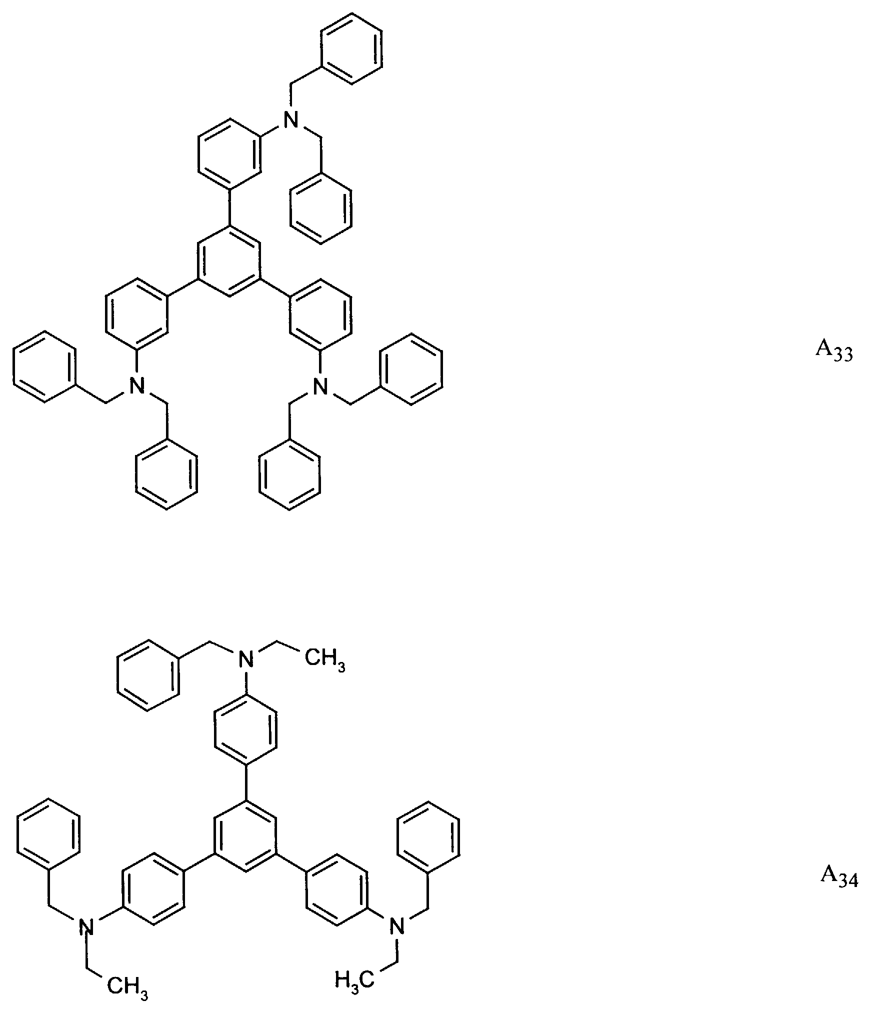

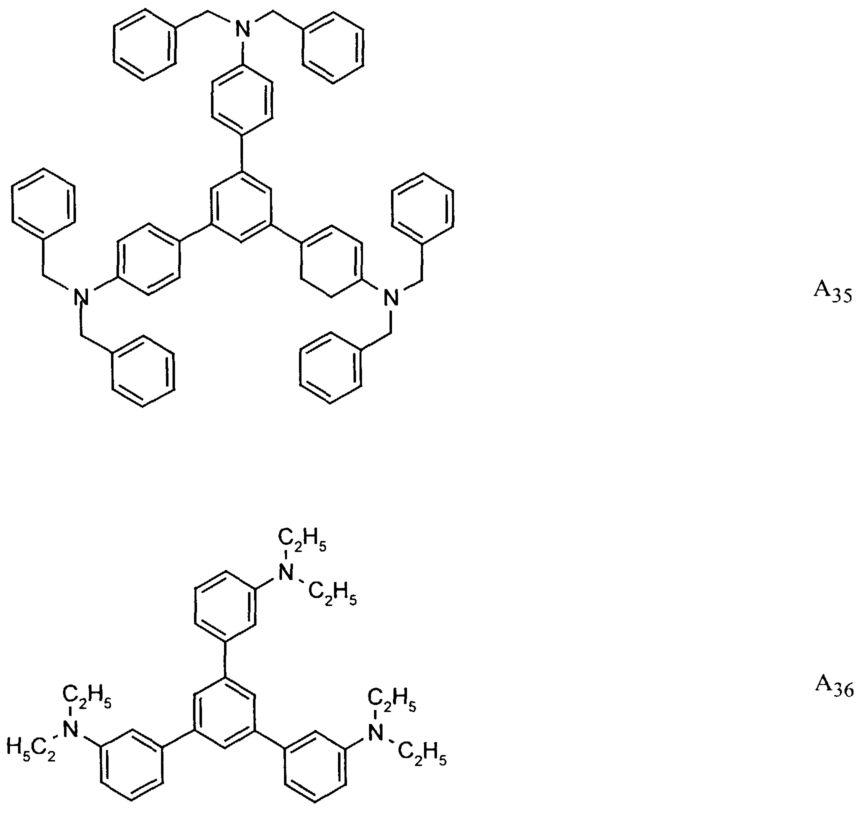

Neben der Komponente A können gegebenenfalls weitere Lochleiter, z.B. in Form einer Mischung mit der Komponente A, zum Aufbau der elektrolumineszierenden Elemente eingesetzt werden. Dabei kann es sich einerseits um eine oder mehrere Verbindungen der Formel (I), wobei auch Gemische von Isomeren umfaßt werden, andererseits auch um Mischungen von lochtransportierenden Verbindungen mit Verbindungen von A - mit der allgemeinen Formel (I) - mit verschiedener Struktur handeln.

Eine Zusammenstellung möglicher lochinjizierender und lochleitender Materialien ist in EP-A 532 798 angegeben.

Im Falle von Mischungen der Komponente A) können die Verbindungen in einem beliebigen Verhältnis zwischen 0 und 100 Gew.-% (bezogen auf die Mischung A)) eingesetzt werden. In einer bevorzugten Ausführungsform werden 1 bis 99 Gew.-% und 99 bis 1 Gew.-%, besonders bevorzugt 5 bis 95 Gew.-% und 95 bis 5 Gew.-% eingesetzt. In einer weiteren bevorzugten Ausführungsform werden 30 bis 70 Gew.-% bzw. 70 bis 30 Gew.-% eingesetzt.

Beispielhaft seien genannt:

Anthracen-Verbindungen, z.B. 2,6,9,10-Tetraisopropoxyanthracen; Oxadiazol-Verbindungen, z.B. 2,5-Bis(4-diethylaminophenyl)-1,3,4-oxadiazol, Triphenylamin-Verbindungen, z.B. N,N'-Diphenyl-N,N'-di(3-methylphenyl)-1,1'-biphenyl-4,4'-diamin; aromatische tertiäre Amine, z.B. N-Phenylcarbazol, N-Isopropyl-carbazol und Verbindungen, die in lochtransportierenden Schichten einsetzbar sind, wie sie in der japanischen Patentanmeldung Offenlegungsnr. 62-264 692 beschrieben sind; ferner Pyrazolin-Verbindungen, z.B. 1-Phenyl-3-(p-diethylaminostyryl)-5-(p-diethylaminophenyl)-2-pyrazolin; Styryl-Verbindungen, z.B. 9-(p-Diethylaminostyryl)-anthrazen; Hydrazon-Verbindungen, z.B. Bis-(4-dimethylamino-2-methylphenyl)-phenyl-methan; Stilben-Verbindungen, z.B. α-(4-Methoxyphenyl)-4-N,N-diphenylamino-(4'-methoxy)stilben, Enamin-Verbindungen, z.B. 1,1-(4,4'-diethoxyphenyl)-N,N-(4,4'-dimethoxyphenyl)enamin; Metall- oder Nichtmetall-Phthalocyanine und Porphyrin-Verbindungen.

Bevorzugt sind Triphenylamin-Verbindungen und/oder aromatische tertiäre Amine, wobei die beispielhaft genannten Verbindungen besonders bevorzugt sind.

Materialien, die lochleitende Eigenschaften aufweisen und als Mischpartner zur Komponente A eingesetzt werden können, sind beispielsweise

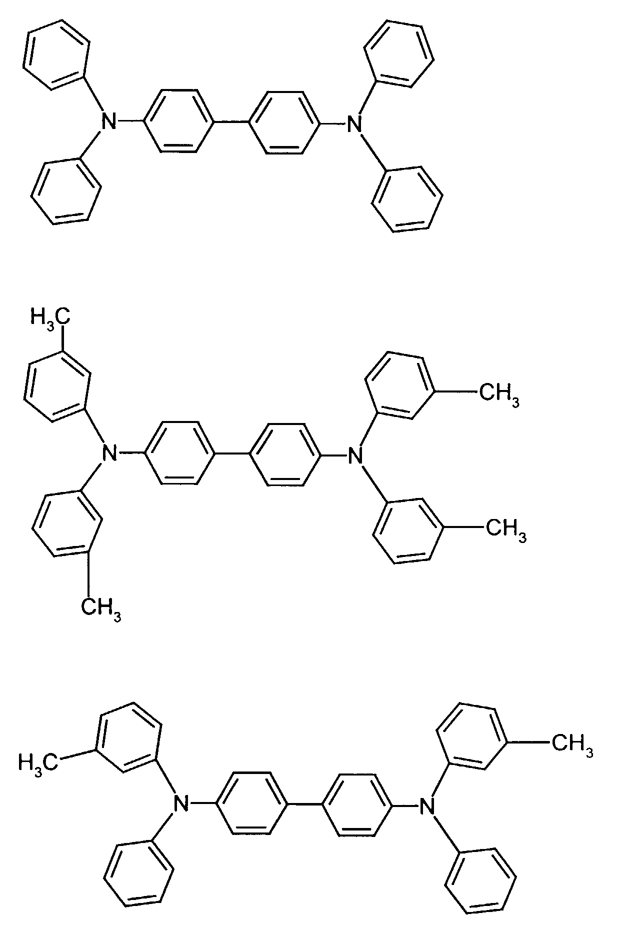

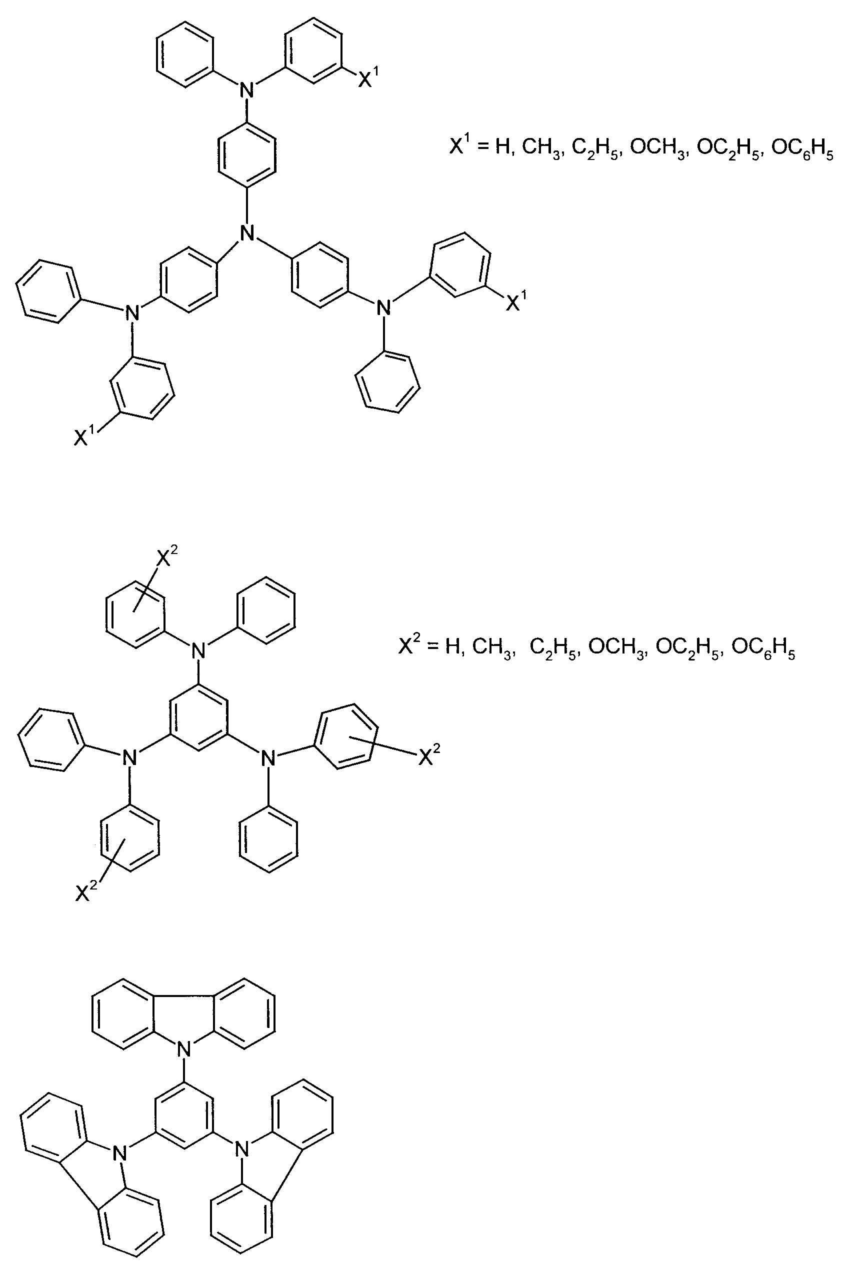

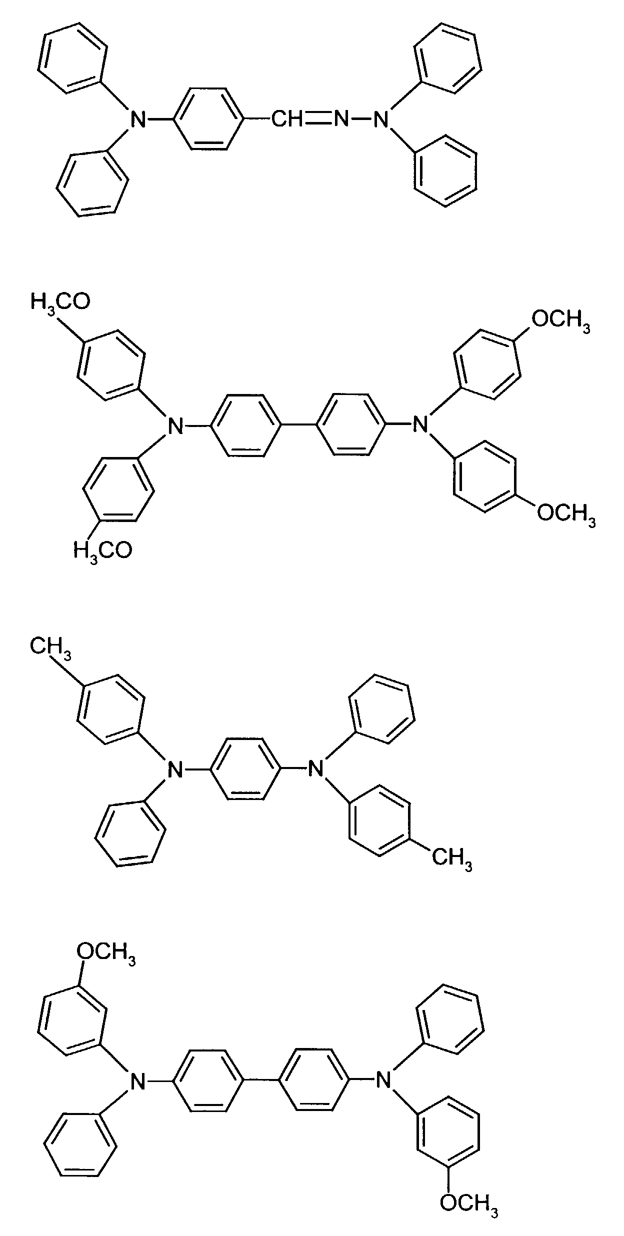

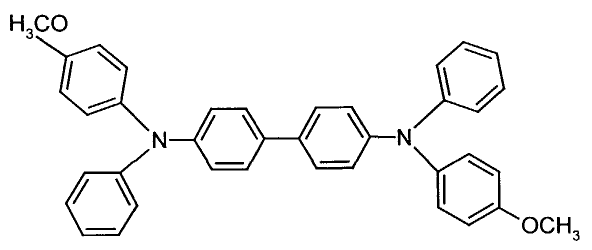

Diese und weitere Beispiele sind beschrieben in J. Phys. Chem. 1993, 97, 6240-6248 und Appl. Phys. Lett., Vol. 66, No. 20, 2679-2681.

Die Komponente B) steht für eine Verbindung der allgemeinen Formel (II) 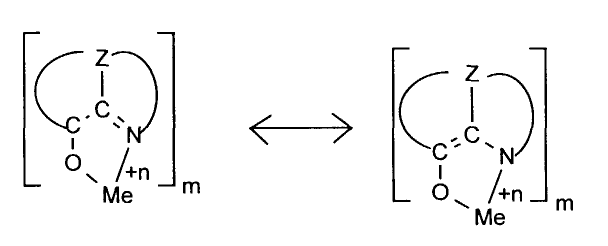 worin
- Me: für ein Metall steht,
- m: eine Zahl von 1 bis 3 ist und
- Z: unabhängig in beiden Formen für Atome steht, die einen Kern vervollständigen, der wenigstens aus 2 kondensierten Ringen besteht.

Generell können ein-, zwei- oder dreiwertige Metalle benutzt werden, von denen bekannt ist, daß sie Chelate bilden.

Das Metall kann ein ein-, zwei- oder dreiwertiges Metall sein, vorzugsweise der 1., 2. und 3. Hauptgruppe und 2. Nebengruppe des Periodensystems, beispielsweise Lithium, Natrium, Kalium, Magnesium, Calcium, Bor, Aluminium, Indium, Gallium, Zink und Beryllium.

Z vervollständigt ein heterocyclisches Molekülteil, das wenigstens aus zwei kondensierten Ringen besteht, von denen einer ein Azol- oder Azinring ist, wobei weitere zusätzliche aliphatische oder aromatische Ringe an die beiden annelierten Ringe angebunden sein können.

Geeignete Beispiele für die Komponente B) sind die Oxin-Komplexe (8-Hydroxy-chinolin-Komplexe) von Al³⁺, Mg²⁺, In³⁺, Ga³⁺, Zn²⁺, Be²⁺, Li⁺, Ca²⁺, Na⁺ oder Aluminiumtris(5-methyloxin) und Galliumtris(5-chloro-chinolin). Auch Komplexe mit Seltenenerd-Metallen sind einsetzbar.

Beispiele für Komponente B sind
Alq₃ q = 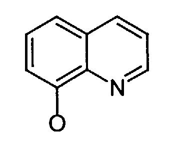 Inq₃, Gaq₃, Znq₂, Beq₂, Mgq₂,
oder Al(qa)₃, Ga(qa)₃, In(qa)₃, Zn(qa)₂, Be(qa)₂, Mg(qa)₂ wobei
(qa) für 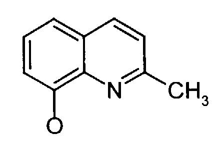 steht.

Es können eine oder mehrere Verbindungen der Komponente B) eingesetzt werden.

Die Verbindungen bzw. Oxin-Komplexe gemäß B) sind allgemein bekannt bzw. lassen sich nach bekannten Verfahren herstellen (vgl. z.B. US-A 4 769 292).

Die substituierten Chinacridon-Verbindungen C) haben folgende allgemeine Formeln (IIIa) und (IIIb) 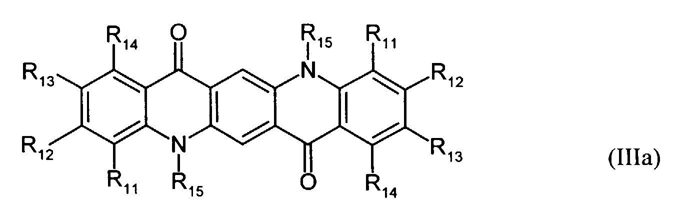 in welcher
- R₁₁, R₁₂, R₁₃ und R₁₄: unabhängig voneinander für Wasserstoff; Halogen und gegebenenfalls durch Halogen substituiertes C₁-C₁₅-Alkyl, C₁-C₁₆-Alkoxy, C₁-C₂₀-Alkylthio, Cycloalkyl, gegebenenfalls substituiertes Aryl oder Arylalkyl stehen, wobei mindestens 2 Reste pro äußeren Phenylring nicht gleichzeitig für Wasserstoff stehen und zusätzlich eine Alkylierung an beiden Stickstoff-Atomen vorhanden sein kann,
- R₁₅: steht für Wasserstoff oder gegebenenfalls substituiertes C₁-C₁₈-Alkyl oder gegebenenfalls substituiertes Cycloalkyl.
- R₁₁, R₁₂, R₁₃ und R₁₄: stehen unabhängig voneinander bevorzugt für C₁-C₆-Alkyl, insbesondere Methyl, tert.-Butyl, C₁-C₁₂-Alkoxy, insbesondere Methoxy, Dodecyloxy, und C₄-C₁₀-Alkylthio, insbesondere Octylthio, Halogen-C₁-C₄-Alkyl, insbesondere Trifluormethyl.
- R₁₅: steht bevorzugt für Wasserstoff, C₁-C₈-Alkyl, insbesondere Methyl, Octyl, tert.-Butyl oder Cyclohexyl.

Halogen steht vorzugsweise für Fluor, Chlor, Brom.

Als Beispiele für derartige Verbindungen seien genannt:

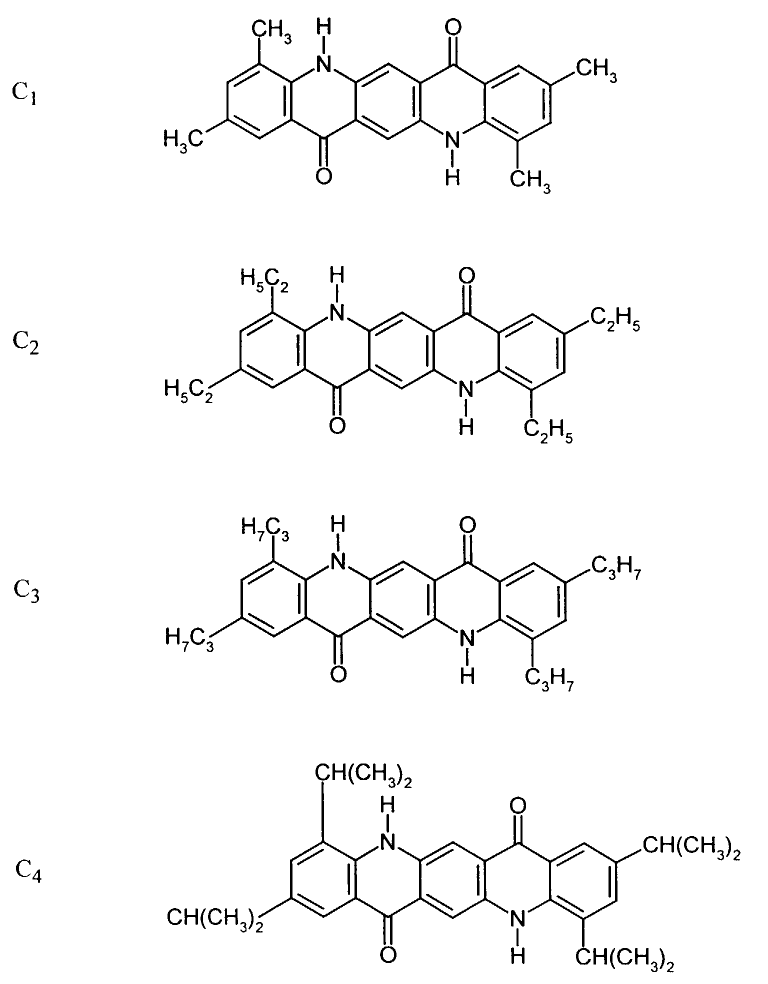

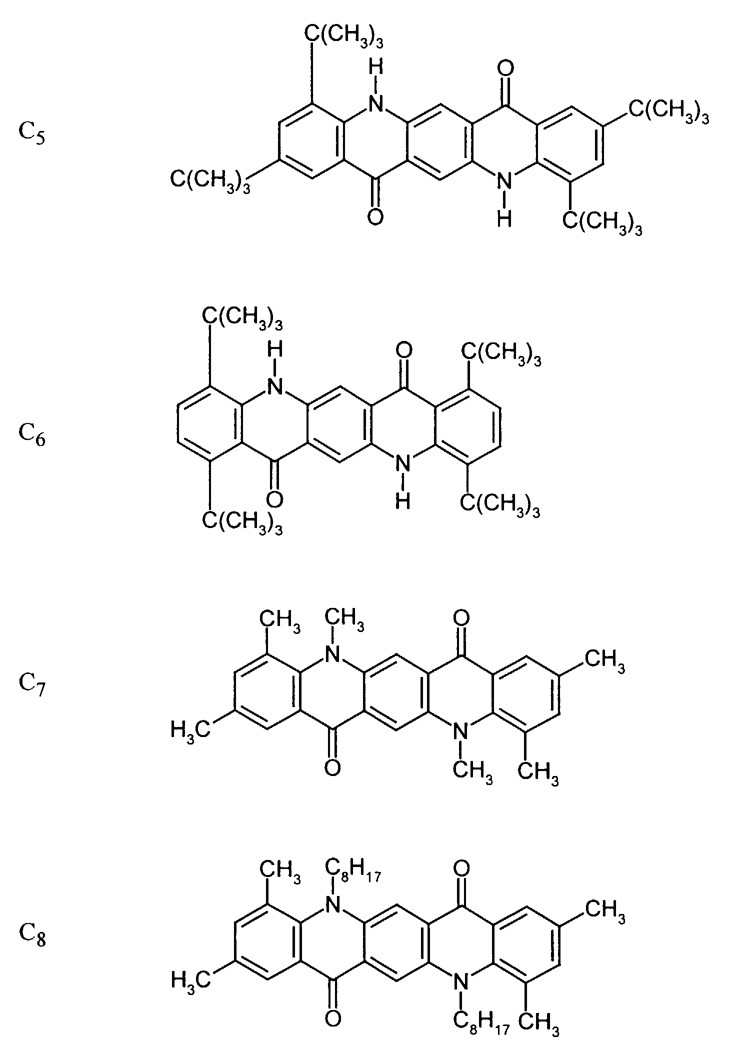

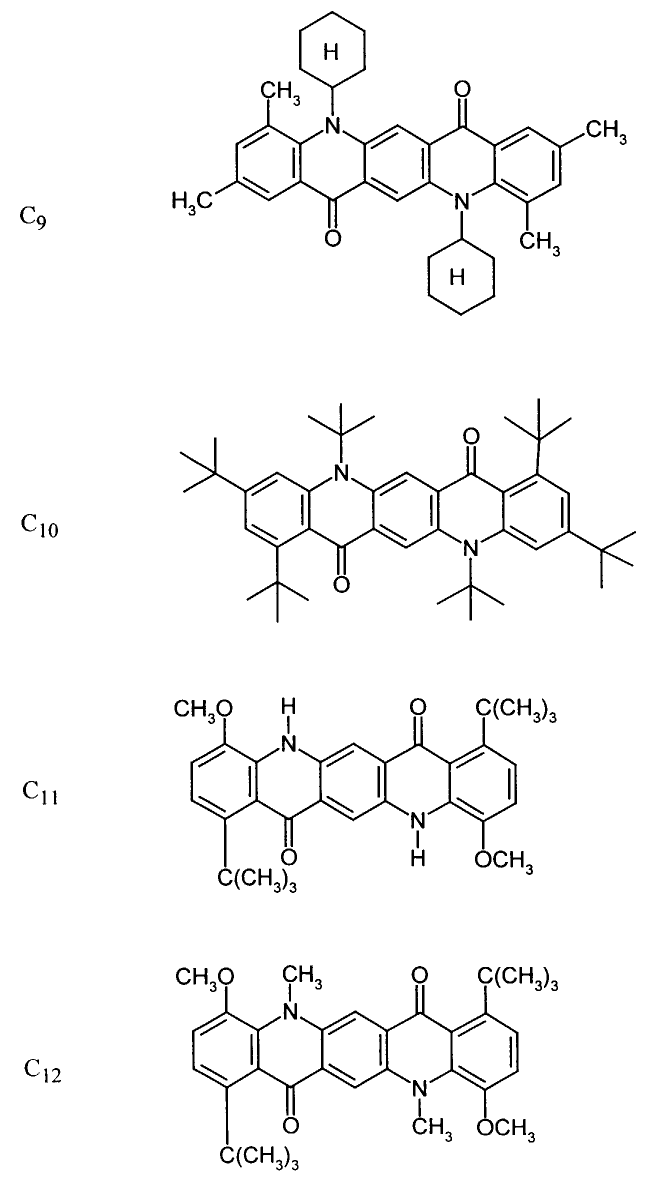

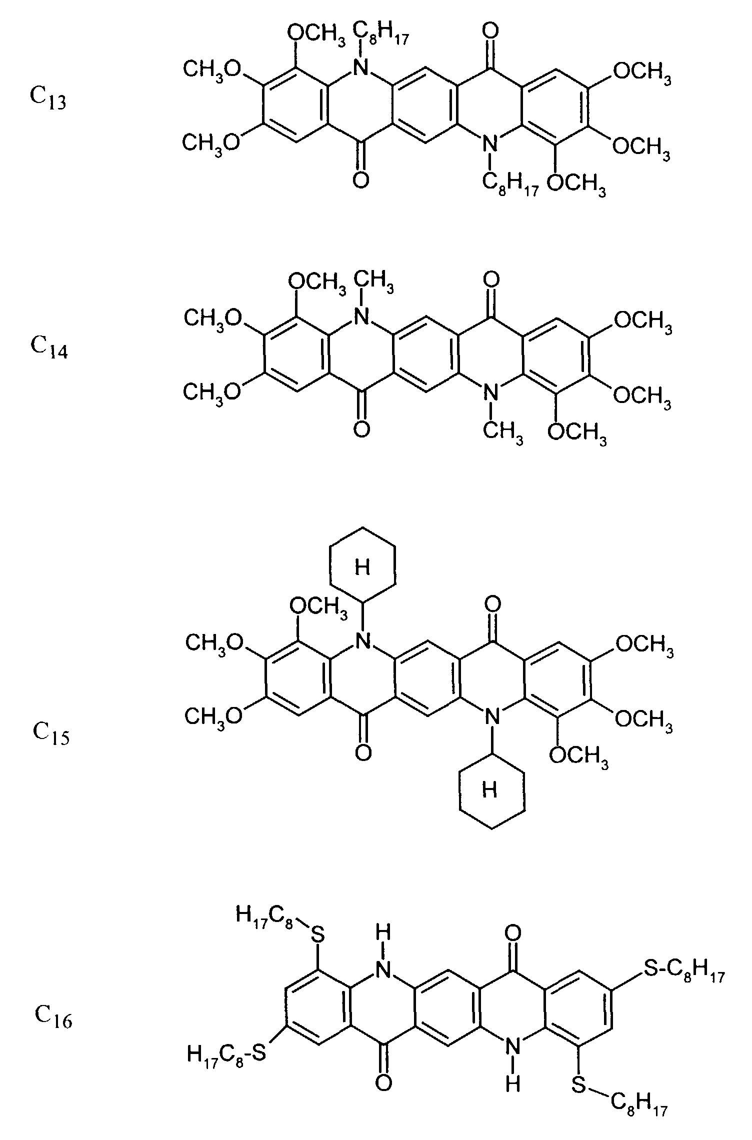

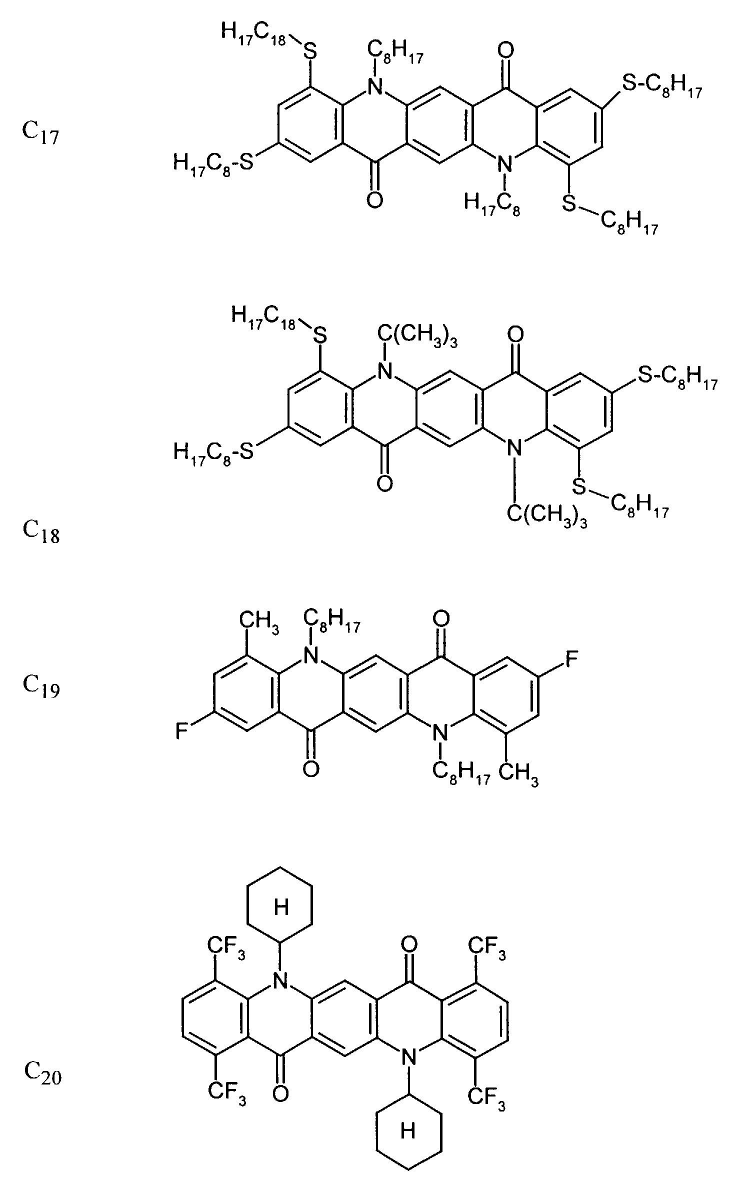

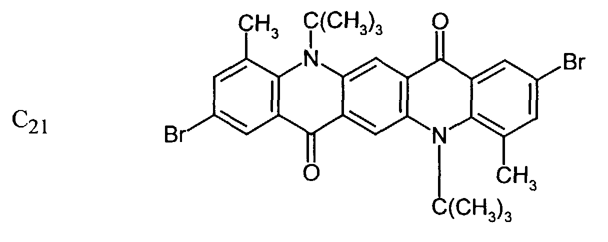

Die substituierte Chinacridon-Verbindung C) kann auch folgende allgemeine Formeln (IIIb) haben (Stereoisomere): 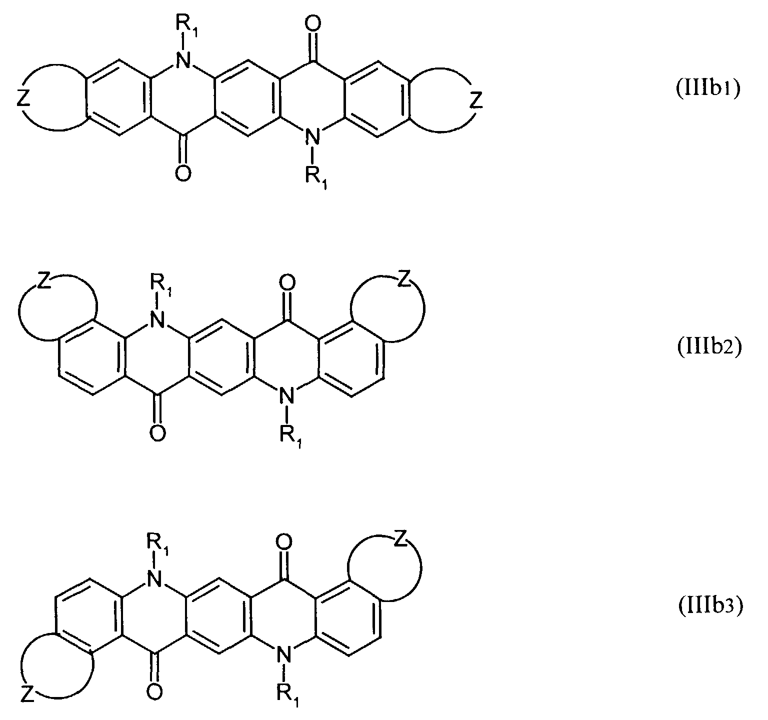 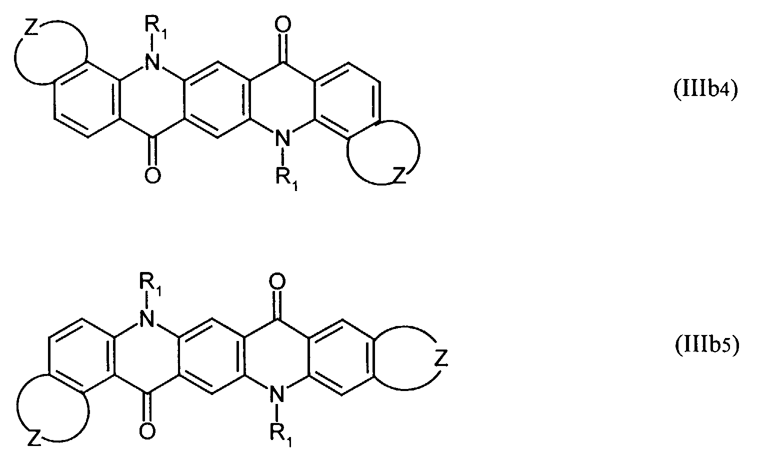 worin
- Z: unabhängig in den beiden Ringen für Atome steht, die einen Ring vervollständigen, vorzugsweise für einen aliphatischen Ring mit 3 bis 12 Kohlenstoffatomen, der durch ein oder mehrere, insbesondere 2 bis 5, Sauerstoffatome unterbrochen sein kann,
- R₁: steht für Wasserstoff, C₁-C₁₆-Alkyl, vorzugsweise C₁-C₁₀-Alkyl, insbesondere Methyl, Octyl, tert.-Butyl, oder Cyclohexyl.

Als Beispiele für derartige Verbindungen seien genannt:

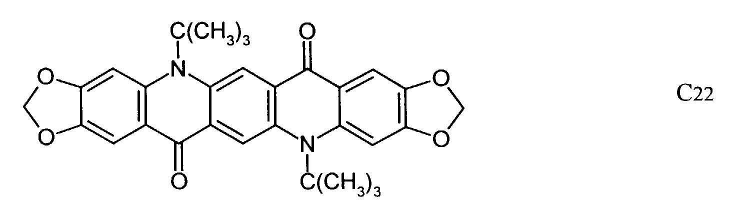

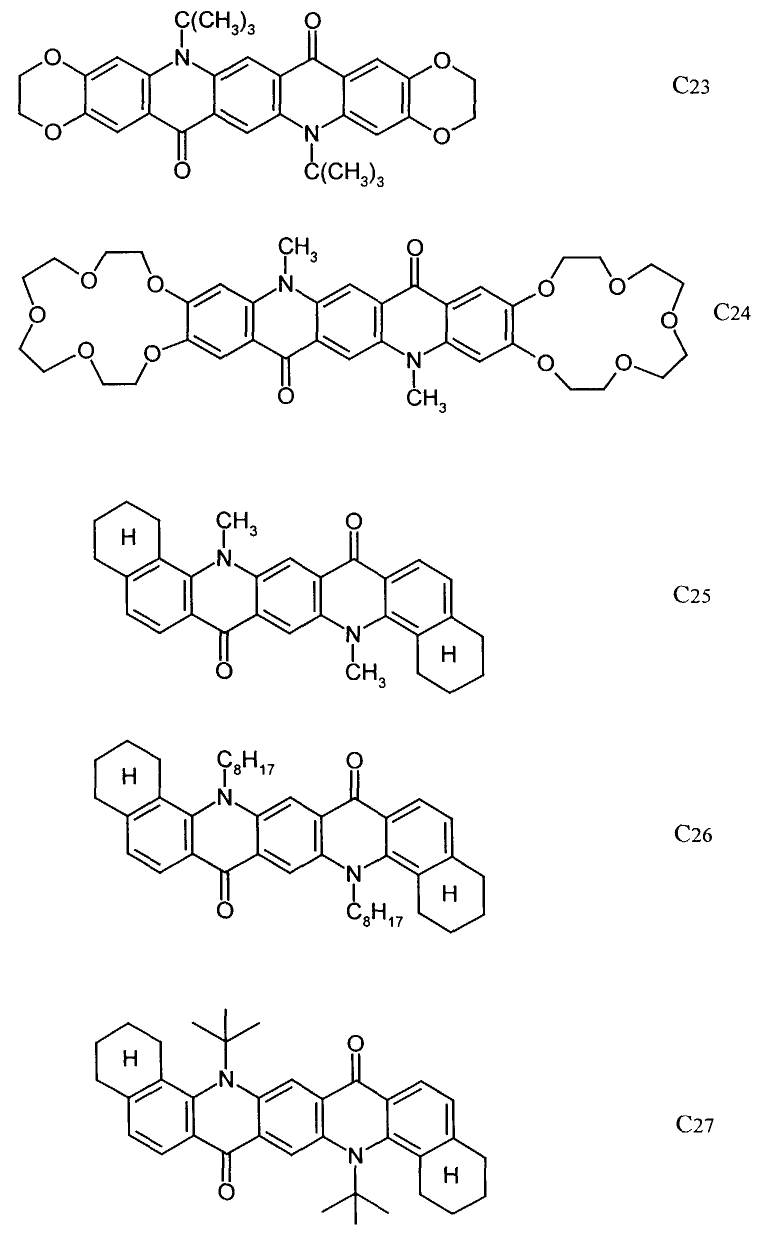

Komponente C kann auch Mischungen aus möglichen Stereoisomeren der allgemeinen Formen (IIIa) und (IIIb) sein.

Die Chinacridon-Derivate der Formel (III) sind bekannt oder lassen sich nach bekannten Methoden herstellen, vgl. beispielsweise das folgende Reaktionsschema:

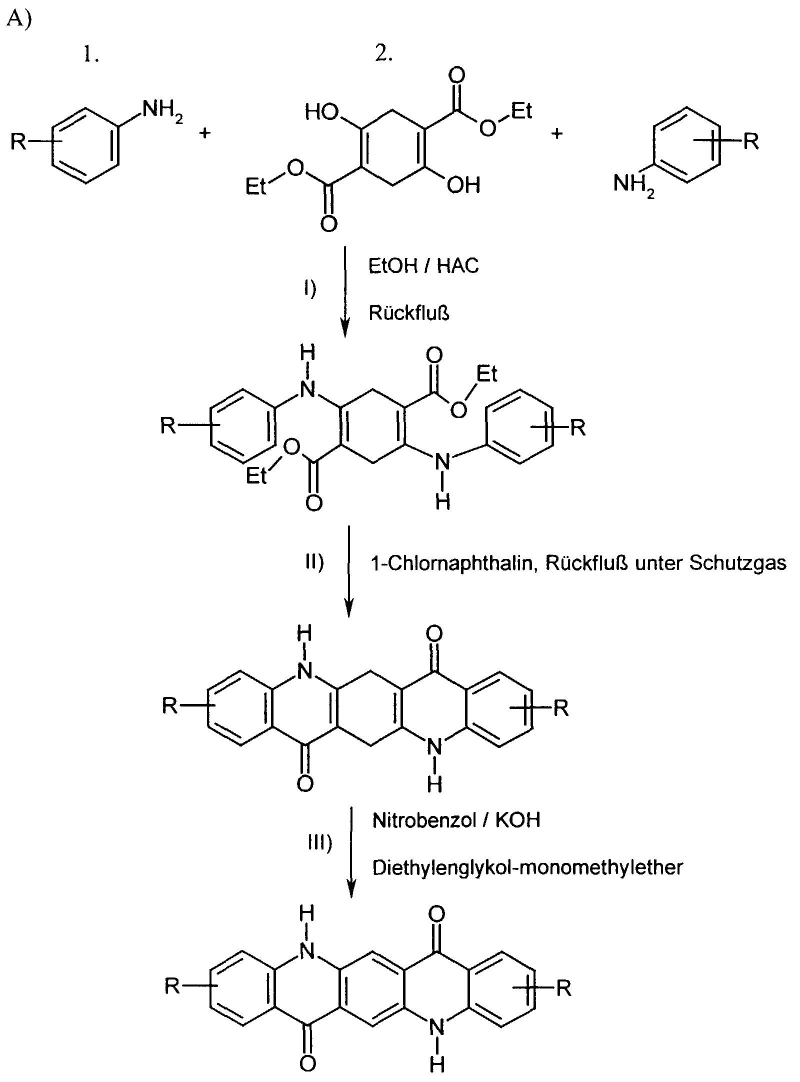

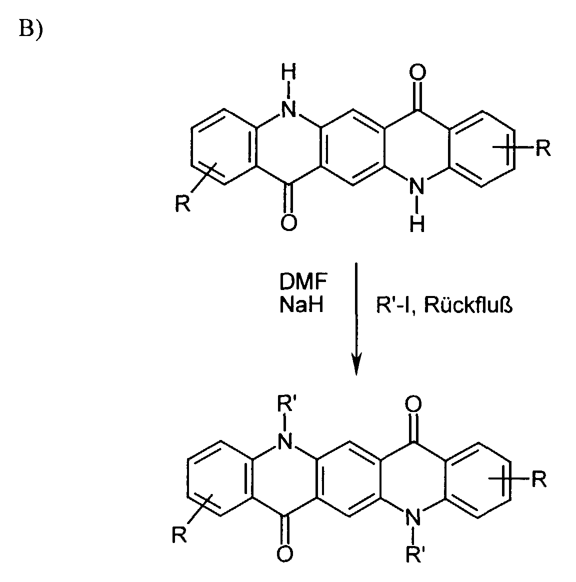

R bzw. R' stehen für einen oder mehrere Reste R₁₁, R₁₂, R₁₃, R₁₄ und haben die oben angegebene Bedeutung.

Die Ausgangsstoffe sind bekannt, käuflich oder lassen sich nach allgemein bekannten Methoden der organischen Chemie herstellen.

Der Binder D) steht für Polymere und/oder Copolymere wie z.B. Polycarbonate, Polyestercarbonate, Copolymere des Styrols wie SAN oder Styrolacrylate, Polysulfone, Polymerisate auf Basis von Vinylgruppen-haltigen Monomeren wie z.B. Poly(meth)acrylate, Polyvinylpyrrolidon, Polyvinylcarbazol, Vinylacetat- und Vinylalkoholpolymere und -copolymere, Polyolefine, cyclische Olelfincopolymere, Phenoxyharze usw. Es können auch Mischungen verschiedener Polymere eingesetzt werden. Die polymeren Binder C) weisen Molekulargewichte von 10 000 bis 2 000 00 g/mol auf, sind löslich und filmbildend und sind im sichtbaren Spektralbereich transparent. Sie sind z.B. beschrieben in Encyclopedia of Polymer Science and Engineering, 2^{nd} Ed. bei A. Wiley-Intersciencepublication. Sie werden üblicherweise in einer Menge bis zu 95, vorzugsweise bis zu 80 Gew.-%, bezogen auf das Gesamtgewicht aus A) und B), eingesetzt.

Die erfindungsgemäßen elektrolumineszierenden Anordnungen sind dadurch gekennzeichnet, daß sie eine lichtemittierende Schicht aufweisen, die eine Mischung der Komponenten A), B) und C) in gegebenenfalls einem transparenten Binder D) enthält. Dabei ist das Gewichtsverhältnis von A), B) und C untereinander variabel einstellbar.

Die Summe der Gewichtsanteile von A) und B) im polymeren Binder liegt im Bereich von 0,2 bis 98 Gew.-%, bevorzugt von 2 bis 95 Gew.-%, besonders bevorzugt von 10 bis 90 Gew.-%, ganz besonders bevorzugt 10 bis 85 Gew.-%.

Das Gewichtsverhältnis A:B der Bestandteile A und B liegt zwischen 0,05 und 20, bevorzugt 0,2 und 10 und besonders bevorzugt zwischen 0,3 und 8, insbesondere 0,3 bis 7. Die Komponenten A) und B) können entweder aus einem Bestandteil oder einem Gemisch von Bestandteilen beliebiger Zusammensetzung bestehen.

Die Chinacridon-Verbindung C) befindet sich im elektrolumineszierenden Element, wobei sie als Dotierstoff in geringer Konzentration in einer beliebigen Schicht enthalten sein kann. Es ist auch möglich, daß sie gleichzeitig in mehreren Schichten des EL-Elements in jeweils unterschiedlicher Konzentration enthalten ist.

Bevorzugt ist der Dotierstoff der Löcher-transportierenden Schicht und/oder Lichtemittierenden Schicht und/oder Elektronen-transportierenden Schicht zugegeben, ganz besonders bevorzugt der lichtemittierenden-transportierenden Schicht.

Die Konzentration von C) in der jeweiligen Gastmatrix liegt unabhängig voneinander zwischen 0,01 bis 40 Gew.-%, bevorzugt zwischen 0,4 bis 10 Gew.-% (bezogen auf 100 Gew.-% Komponente A) und B)).

Zur Herstellung der Schicht werden die Komponenten A), B), C) und gegebenenfalls D) in einem geeigneten Lösemittel gelöst und durch Gießen, Rakeln oder spincoating auf eine geeignete Unterlage aufgebracht. Dabei kann es sich z.B. um Glas oder ein Kunststoffmaterial handeln, das mit einer transparenten Elektrode versehen ist. Als Kunststoffmaterial kann z.B. eine Folie aus Polycarbonat, Polyester wie Polyethylenterephthalat oder Polyethylennaphthalat, Polysulfon oder Polyimid eingesetzt werden.

Als transparente Elektroden sind geeignet
a) Metalloxide, z.B. Indium-Zinn-Oxid (ITO), Zinnoxid (NESA), Zinkoxid, dotiertes Zinnoxid, dotiertes Zinkoxid, etc.,
b) semi-transparente Metallfilme, z.B. Au, Pt, Ag, Cu etc.,
c) leitfähige Polymerfilme wie Polyaniline, Polythiophene, etc.

Die Metalloxid- und die semitransparenten Metallfilmelektroden werden durch Techniken wie Aufdampfen, Aufsputtern, Platinierung, etc., in dünner Schicht aufgebracht. Die leitfähigen Polymerfilme werden durch Techniken wie Spincoaten, Casting, Rakeln etc. aus der Lösung aufgebracht.

Die Dicke der transparenten Elektrode beträgt 3 nm bis etwa mehrere µm, vorzugsweise 10 nm bis 500 nm.

Die elektrolumineszierende Schicht wird direkt auf die transparente Elektrode oder auf eine gegebenenfalls vorhandene ladungstransportierende Schicht als dünner Film aufgebracht. Die Dicke des Films beträgt 10 bis 500 nm, vorzugsweise 20 bis 400 nm, besonders bevorzugt 50 bis 250 nm.

Auf die elektrolumineszierende Schicht kann eine weitere ladungstransportierende Schicht eingefügt werden, bevor eine Gegenelektrode aufgebracht wird.

Eine Zusammenstellung von geeigneten ladungstransportierenden Zwischenschichten, bei denen es sich um loch- und/oder elektronenleitenden Materialien handeln kann, die in polymerer oder niedermolekularer Form gegebenenfalls als Blend vorliegen können, ist in EP-A 532 798 aufgeführt. Besonders geeignet sind speziell substituierte Polythiophene, die über lochtransporierende Eigenschaften verfügen. Sie sind beispielsweise in EP-A 686 662 beschrieben. Die genannten Referenzen werden ausdrücklich in die Beschreibung aufgenommen ( 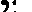 incorporated by reference").

Der Gehalt an niedermolekularem Lochleiter in einem polymeren Binder ist im Bereich von 2 bis 97 Gew.-% variierbar; bevorzugt beträgt der Gehalt 5 bis 95 Gew.-%, besonders bevorzugt 10 bis 90 Gew.-%. Die lochinjizierenden bzw. lochleitenden Zonen können mit verschiedenen Methoden deponiert werden.

Filmbildende Lochleiter können auch in reiner Form (100 %ig) eingesetzt werden. Gegebenenfalls kann auch die lochinjizierende bzw. lochleitende Zone Anteile eines elektrolumineszierenden Materials enthalten.

Blends, die ausschließlich aus niedermolekularen Verbindungen bestehen, können aufgedampft werden; lösliche und filmbildende Blends, die neben niedermolekularen Verbindungen und Dotierstoff auch einen Binder D) enthalten können (nicht notwendigerweise), können aus einer Lösung z.B. mittels Spin-Coating, Gießen, Rakeln deponiert werden.

Es ist auch möglich, emittierende und/oder elektronenleitende Substanzen in einer separaten Schicht auf die lochleitende Schicht mit der Komponente A aufzubringen. Dabei kann eine emittierende Substanz gemäß Komponente C) auch der die Verbindung A enthaltenden Schicht zudotiert ("Dopant") und zusätzlich eine elektronenleitende Substanz aufgebracht werden. Eine elektrolumineszierende Substanz kann auch der elektroneninjizierenden bzw. elektronenleitenden Schicht zugesetzt werden.

Der Gehalt an niedermolekularen Elektronenleitern im polymeren Binder ist im Bereich von 2 bis 95 Gew.-% variierbar; bevorzugt beträgt der Gehalt 5 bis 90 Gew.-%, besonders bevorzugt 10 bis 85 Gew.-%. Filmbildende Elektronenleiter können auch in reiner Form (100 %ig) eingesetzt werden.

Die Gegenelektrode besteht aus einer leitfähigen Substanz, die transparent sein kann. Vorzugsweise eignen sich Metalle, z.B. Al, Au, Ag, Mg, In, etc. oder Legierungen und Oxide dieser, die durch Techniken wie Aufdampfen, Aufsputtern, Platinierung aufgebracht werden können.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 0,1 bis 100 Volt Licht der Wellenlänge von 200 bis 2000 nm. Sie zeigen im Bereich von 200 bis 2000 nm Photolumineszenz.

Die erfindungsgemäßen Anordnungen sind zur Herstellung von Einheiten zur Beleuchtung und zur Informationsdarstellung geeignet.

### Beispiele

### A) Synthese I:

Die Synthese von substituierten Chinacridonen erfolgt in einer 3-Stufen Synthese aus 2,5-Dihydroxy-1,4-cyclohexadien-1,4-di-carbonsäurediethylester (Succinylobernsteinsäurediester) und der entsprechenden Anilinverbindung nach folgendem Reaktionsschema

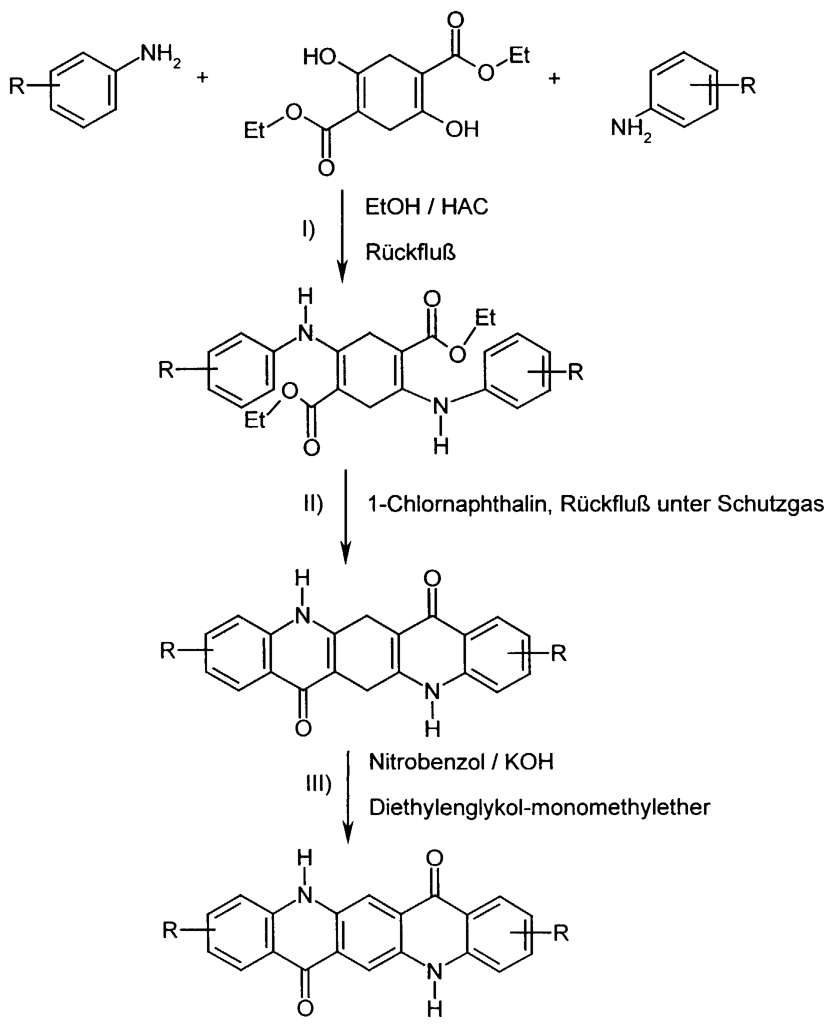

Die einzelnen Syntheseschritte sind näher beschrieben z.B. in:
R.H. Altiparmakian, H. Bohler, B.L. Kaul, F. Kehrer, Helvetica Chimica Acta Vol. 55, 85-100 (1972)
K. Kitahara, H. Yanagimoto, N, Nakajima, H. Nishi, J. Heterocyclic Chem. 29, 167-169 (1992)
V. Keller, K. Müller, S. De Feyter, F.C. De Schryver, Adv. Mater. 8, No. 6, 490-493 (1996).

### Beispiel 1 Synthese von

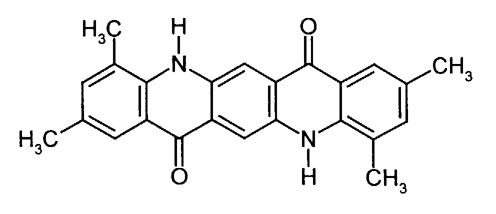

### a) 1. Stufe

4,85 g (40 mmol) 2,4-Dimethylanilin und 5,13 g (20 mmol) 2,5-Di-hydroxy-1,4-cyclohexadien-1,4-di-carbonsäurediethylester werden in einer Mischung aus 1000 ml Ethanol und 400 ml Essigsäure 7 h unter Argon am Rückfluß gekocht. Nach Abkühlung auf Raumtemperatur wird der ausgefallene hellrote Niederschlag abgetrennt und mit warmen, Ethanol gewaschen. Nach dem Trocknen erhält man 2,54 g (27,5 % d.Th.) eines pinkfarbenen Feststoffs, der ohne weitere Reinigung für die 2. Reaktionsstufe eingesetzt werden konnte.

### b) 2. Stufe

2,5 g (5,5 mmol) von Beispiel 1a) werden mit 70 ml 1-Chlornaphthalin versetzt und im Ölpumpenvakuum durch mehrmaliges Evakuieren und Belüften mit Argon gründlich von Sauerstoff befreit. Die Mischung wird auf dem Metallbad bei 260°C 1 h lang am Rückfluß gekocht. Nach dem Abkühlen trennt man das Lösungsmittel unter reduziertem Druck ab. Der erhaltene feste Rückstand wird mehrmals in Aceton gekocht und heiß filtriert, um Nebenprodukte zu entfernen. Nach dem Trocknen erhält man 1,57 g (78 % d.Th.) eines pinkfarbenen Feststoffes.

### c) 3. Stufe

1,5 g (4,1 mmol) Beispiel 1b) und 1,25 g KOH werden in 75 ml Diethylenglykolmonomethylether bei ca. 80°C gelöst. Zur erhaltenen Lösung wird 2,5 ml Nitrobenzol auf einmal zugegeben und anschließend 4,5 Stunden bei 75°C unter Rühren gekocht. Danach wird der Reaktionsansatz mit 10 ml Essigsäure versetzt und 10 Minuten bei Raumtemperatur nachgerührt. Nach Verdünnung mit 60 ml Ethanol wird der erhaltene tiefrote Feststoff abgetrennt und mehrmals mit warmem Ethanol und Ethanol gewaschen. Weitere Reinigung erfolgt mit heißem Tetrahydrofuron (THF). Endreinigung erfolgt durch Sublimation.

### Beispiel 2 Synthese von

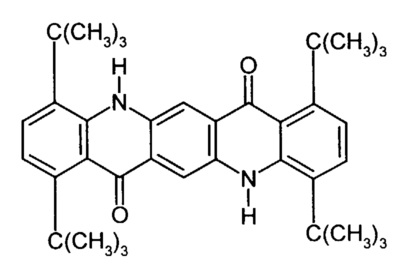

### a) 1. Stufe

30 g (146,1 mmol) 2,5-Di-tert.-butylanilin und 18,7 g (73,05 mmol) 2,5-Di-hydroxy-1,4-cyclohexadien-1,4-di-carbonsäurediethylester werden in einer Mischung aus 1000 ml Ethanol und 400 ml Essigsäure 26 h unter Argon am Rückfluß gekocht.

Nach Abkühlung auf Raumtemperatur wird der ausgefallene hellrote Niederschlag abgetrennt und mit warmem Ethanol gewaschen. Nach dem Trocknen erhält man 33,2 g (72 % d.Th.) eines hellroten Feststoffs, der ohne weitere Reinigung für die 2. Reaktionsstufe eingesetzt werden kann.

### b) 2. Stufe

15 g (23,8 mmol) Beispiel 2a) wird mit 280 ml 1-Chlornaphthalin versetzt und im Ölpumpenvakuum durch mehrmaliges Evakuieren und Belüften mit Argon gründlich von Sauerstoff befreit. Die Mischung wird auf dem Metallbad bei 260°C 3 h lang am Rückfluß gekocht. Nach dem Abkühlen trennt man das Lösungsmittel unter reduziertem Druck ab. Der erhaltene feste Rückstand wird mehrmals in Aceton gekocht und heiß filtriert, um Nebenprodukte zu entfernen. Nach dem Trocknen erhält man 5 g (39 % d.Th.) eines pinkfarbenen Feststoffes.

### c) 3. Stufe

5 g (9,3 mmol) Beispiel 2b) und 3,7 g KOH werden in 200 ml Diethylenglykolmonomethylether bei ca. 80°C gelöst Zur erhaltenen Lösung wird 7,5 ml Nitrobenzol auf einmal zugegeben und anschließend ca. 4 Stunden bei 75°C unter Rühren gekocht. Danach wird der Reaktionsansatz mit 10 ml Essigsäure versetzt und 10 Minuten bei Raumtemperatur nachgerührt. Nach Verdünnung mit 100 ml Ethanol wird der erhaltene tiefrote Feststoff abgetrennt und mehrmals mit warmem Ethanol und Methanol gewaschen. Weitere Reinigung erfolgt mit heißem THF. Nach dem Trocknen erhält man 0,66 g (13,2% d.Th.) eines roten Feststoffs. Endreinigung erfolgt durch Sublimation.

### Beispiel 3 Synthese von

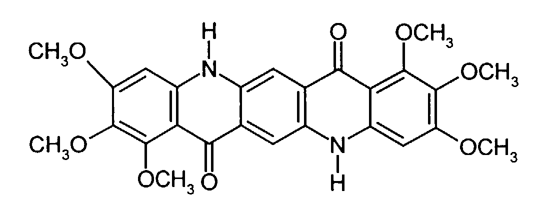

### a) 1. Stufe

14,3 g (78,04 mmol) 3,4,5Trimethoxyanilin und 10 g (39,02 mmol) 2,5-Di-hydroxy-1,4-cyclohexadien-1,4-di-carbonsäurediethylester werden in einer Mischung aus 500 ml Ethanol und 200 ml Essigsäure 26 h unter Argon am Rückfluß gekocht. Nach Abkühlung auf Raumtemperatur wird der ausgefallene hellrote Niederschlag abgetrennt und mit warmem Ethanol gewaschen. Nach dem Trocknen erhält man 18,25 g (79,7 % d.Th.) eines hellroten Feststoffs, der ohne weitere Reinigung für die 2. Reaktionsstufe eingesetzt werden konnte.

### b) 2. Stufe

5 g (8,52 mmol) Beispiel 3a) wird mit 85 ml 1-Chlornaphthalin versetzt und im Ölpumpenvakuum durch mehrmaliges Evakuieren und Belüften mit Argon gründlich von Sauerstoff befreit. Die Mischung wird auf dem Metallbad bei 260°C 3 h lang am Rückfluß gekocht. Nach dem Abkühlen trennt man das Lösungsmittel unter reduziertem Druck ab. Der erhaltene feste Rückstand wird mehrmals in Aceton gekocht und heiß filtriert, um Nebenprodukte zu entfernen. Nach dem Trocknen erhält man 32,6 g (77,3% d.Th.) eines pinkfarbenen Feststoffes.

### c) 3. Stufe

3 g (6,06 mmol) Beispiel 2b) und 3,5 g KOH werden in 200 ml Diethylenglykolmonomethylether bei ca. 80°C gelöst. Zur erhaltenen Lösung wird 7,0 ml Nitrobenzol auf einmal zugegeben und anschließend ca. 4 Stunden bei 75°C unter Rühren gekocht. Danach wird der Reaktionsansatz mit 10 ml Essigsäure versetzt und 10 Minuten bei Raumtemperatur nachgerührt. Nach Verdünnung mit 100 ml Ethanol wird der erhaltene tiefrote Feststoff abgetrennt und mehrmals mit warmem Ethanol und Methanol gewaschen. Weitere Reinigung erfolgt mit heißem THF. Nach dem Trocknen erhält man 1,57 g (52,5% d.Th.) eines roten Feststoffs. Endreinigung erfolgt durch Sublimation.

Nach analogen Verfahren wie in den Beispielen 1 bis 3 lassen sich je nach Anilingrundkomponente sämtliche Chinacridon-Grundstrukturen synthetisieren, die in einem anschließenden N-Alkylierungsschritt weiter umgesetzt werden:

### Synthese II:

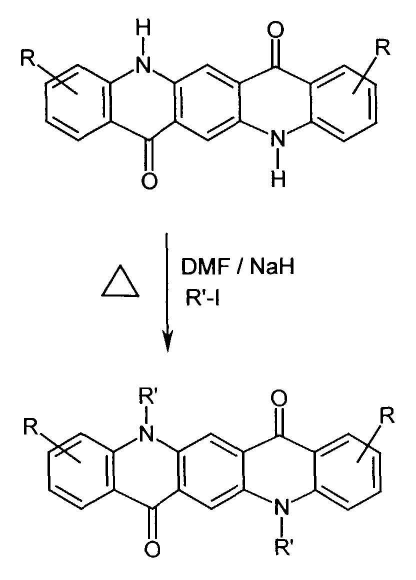

N,N-Dialkylchinacridon-Derivat

### B) EL-Anordnungen:

### Beispiel 1

Die Substanz C₆ wurde in Methanol gelöst, so daß die Extinktion bei 500 nm in einer 10 nm Quarzkuvete E = 0,04 beträgt. Von dieser Lösung wurde eine Floureszenzund ein Anregungsspektrum an einem Fluoreszenzspektrometer (Edinburgh, FS 900) aufgenommen, Abb.1. Das Maximum des Anregungspektrums liegt bei 505 nm, das Maximum der Emission bei 540 nm. Die Quantenausbeute der Substanz in Methanol bei Anregung λex = 505 nm beträgt ⌀ =0,33.

### Beispiel 2

Die erfindungsgemäße Substanz C₆ wird zum Aufbau einer organischen Leuchtdiode (OLED) genutzt. Bei der Herstellung der OLED wird folgendermaßen vorgegangen:
1. Reinigung des ITO-Substrats
   ITOa-beschichtetes Glas (Merck Balzers AG, Deutschland, FL, Part. No. 253 674 XO) wird in 50 mm x 50 mm-große Stücke (Substrate) geschnitten. Die Substrate werden anschließend in 3 %iger wäßriger Mukasollösungen im Ultraschalbad 15 min lang gereinigt. Danach werden die Substrate mit destilliertem wasser gespült und in einer Zentrifuge trocken geschleudert. Dieser Spül- und Trockenvorgang wird 10 mal wiederholt.
2. Aufbringen der Baytron P-Schicht auf das ITO
   Etwa 10 ml der 1,3 %igen Polyethylendioxythiophen/Polysulphonsäure-Lösung (Bayer AG, Leverkusen, Deutschland, Baytron P) werden filtriert (Millipore HV, 0,45 µm). Das Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 200).
3. Aufbringen der lichtemittierenden Schicht
   5 ml einer 0,5 %igen Dichlorethanlösung aus 1 Gew.-Teil Polyvinylcarbazol (BASF AG, Ludwigshafen, Deutschland, Luvican), 1 Gew.-Teil Phenylamin und 0,2 Gew.-Teilen C₆ werden filtriert (Millipore HV, 0,45 µm) und auf der getrockneten Baytron-P-Schicht verteilt. Anschließend wird die überstehende Lösung durch Rotation des Tellers bei 100 U/min 30 sec lang abgeschleudert. Danach wird das so beschichtete Substrat 5 min lang bei 110°C auf einer Heizplatte getrocknet. Die Gesamtschichtdicke beträgt 150 nm.
4. Aufdampfen der Metallkathode
   Auf das organische Schichtsystem wird eine metallelektrode gedampft. Dazu wird das Substrat mit dem organischen Schichtsystem nach unten auf eine Lockmaske (Lochdurchmesser 5 mm) gelegt. Aus zwei Aufdampfschiffchen werden bei einem Druck von 10⁻³ Pa parallel die Elemente Mg und Ag verdampft. Die Aufdampfraten betragen für Mg: 28 Å/sec und für Ag: 2 Å/sec. Die Dicke der aufgedampften Metallkontakte beträgt 500 nm.

Die beiden Elektroden der organischen LED werden über elektrische Zuführungen mit einer Spannungsquelle verbunden. Der positive Pol ist mit der ITO-Elektrode, der negative Pol ist mit der Mg/Ag-Elektrode verbunden.

Bereits ab einer Spannung von 2,5 Volt läßt sich mit einer Photodiode (EG&G C30809E) Elektrolumineszenz nachweisen. Bei einer Spannung von 3 Volt fließt ein Flächenstrom von 1 m/A/cm² und die Elektrolumineszenz ist gut sichtbar. Die Farbe der Elektrolumineszenz ist grün-gelb.

## Patentansprüche

1. Elektrolumineszierende Anordnungen, aufgebaut aus einem Substrat, einer Anode, einem elektrolumineszierenden Element und einer Kathode, wobei wenigstens eine der beiden Elektroden im sichtbaren Spektralbereich transparent ist und das elektrolumineszierende Element eine oder mehrere Zonen aus der Gruppe der lochinjizierenden Zone, lochtransportierenden Zone, elektrolumineszierenden Zone, elektronentransportierenden Zone und elektroneninjizierenden Zone in der genannten Reihenfolge enthält, wobei jede der vorhandenen Zonen auch die Funktion der anderen genannten Zonen übernehmen kann, dadurch gekennzeichnet, daß die lochinjizierende und/oder lochtransportierende Zone eine gegebenenfalls substituierte Tris-1,3,5-(aminophenyl)benzolverbindung A), ein lumineszierendes Material B) und ein Chinacridon-Derivat C) enthält.

2. Elektrolumineszierende Anordnung gemäß Anspruch 1, dadurch gekennzeichnet, daß die Chinacridon-Derivate C) Verbindungen der folgenden Formeln (IIIa) 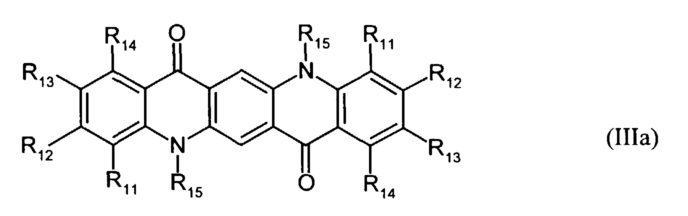 in welcher
R₁₁, R₁₂, R₁₃ und R₁₄ unaghängig voneinander für Wasserstoff, Halogen, gegebenenfalls substituiertes C₁-C₁₅-Alkyl, C₁-C₁₆-Alkoxy, C₁-C₁₆-Alkylthio, C₄-C₈-Cycloalkyl, gegebenenfalls substituiertes Aryl oder Arylalkyl stehen, wobei mindestens 2 Reste pro äußerem Phenylring nicht gleichzeitig für Wasserstoff stehen und zusätzlich eine Alkylierung am Stickstoffatom vorhanden sein kann,
R₁₅ steht für Wasserstoff oder gegebenenfalls substituiertes C₁-C₁₆-Alkyl oder gegebenenfalls substituiertes C₄-C₈-Cycloalkyl,
und/oder eine Verbindung der Formeln (IIIb) 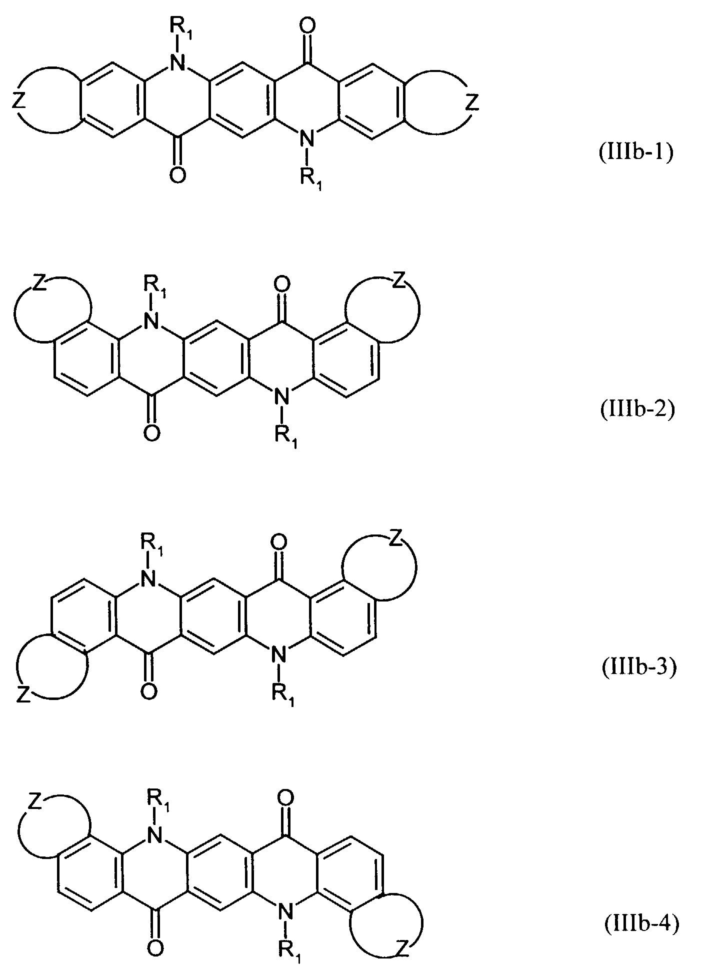 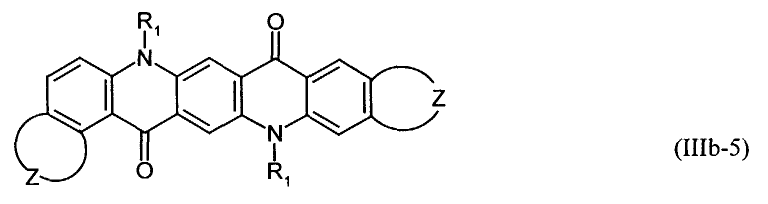 worin
Z unabhängig in den beiden Ringen für Atome steht, die einen Ring vervollständigen und
R¹ für Wasserstoff; C₁-C₁₆-Alkyl oder C₄-C₈-Cycloalkyl steht.

3. Elektrolumineszierende Anordnungen gemäß Anspruch 1, dadurch gekennzeichnet, daß das elektrolumineszierende Element einen transparenten polymeren Binder D) enthält.

4. Elektrolumineszierende Anordnungen gemäß Anspruch 1, dadurch gekennzeichnet, daß die Verbindung A) eine aromatische tertiäre Aminoverbindung der allgemeinen Formel (I) ist 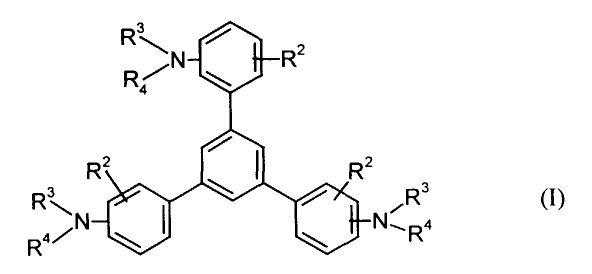 in welcher
R² für Wasserstoff, gegebenenfalls substituiertes Alkyl oder Halogen steht,
R³ und R⁴ unabhängig voneinander für gegebenenfalls substituiertes C₁-C₁₀-Alkyl, Alkoxycarbonyl-substituiertes C₁-C₁₀-Alkyl, jeweils gegebenenfalls substituiertes Aryl, Aralkyl oder Cycloalkyl stehen.

5. Elektrolumineszierende Anordnung gemaß Anspruch 1, dadurch gekennzeichnet, daß in Formel (I)
R² für Wasserstoff oder C₁-C₆-Alkyl steht,
R³ und R⁴ unabhängig voneinander für C₁-C₆-Alkyl, C₁-C₄-Alkoxycarbonyl-C₁-C₆-alkyl, jeweils gegebenenfalls durch C₁-C₄-Alkyl und/oder C₁-C₄-Alkoxy substituiertes Phenyl, Naphthyl, Phenyl-C₁-C₄-alkyl, Naphthyl-C₁-C₄-alkyl, Cyclopentyl oder Cyclohexyl stehen.

6. Elektrolumineszierende Anordnung gemaß Anspruch 1, dadurch gekennzeichnet, daß das tertiäre Amin A) ausgewählt ist aus den folgenden Verbindungen:

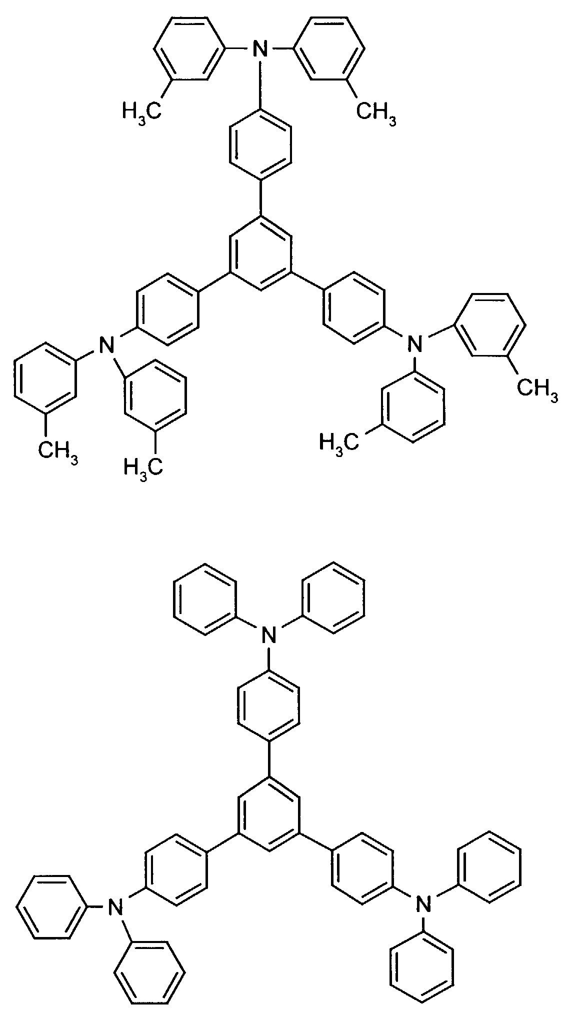

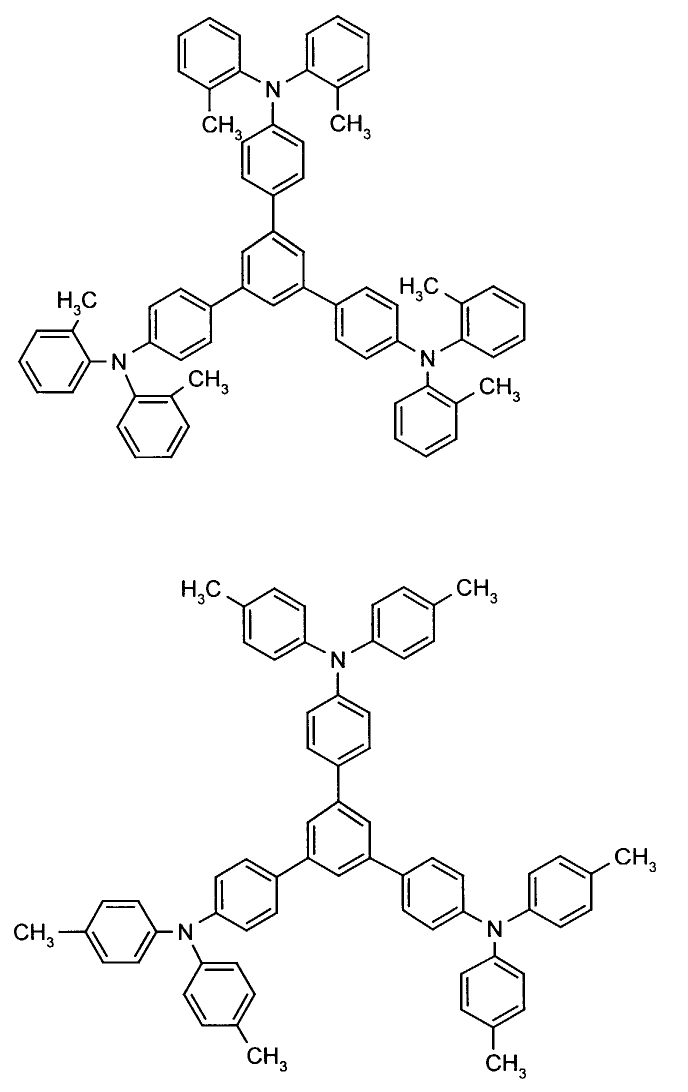

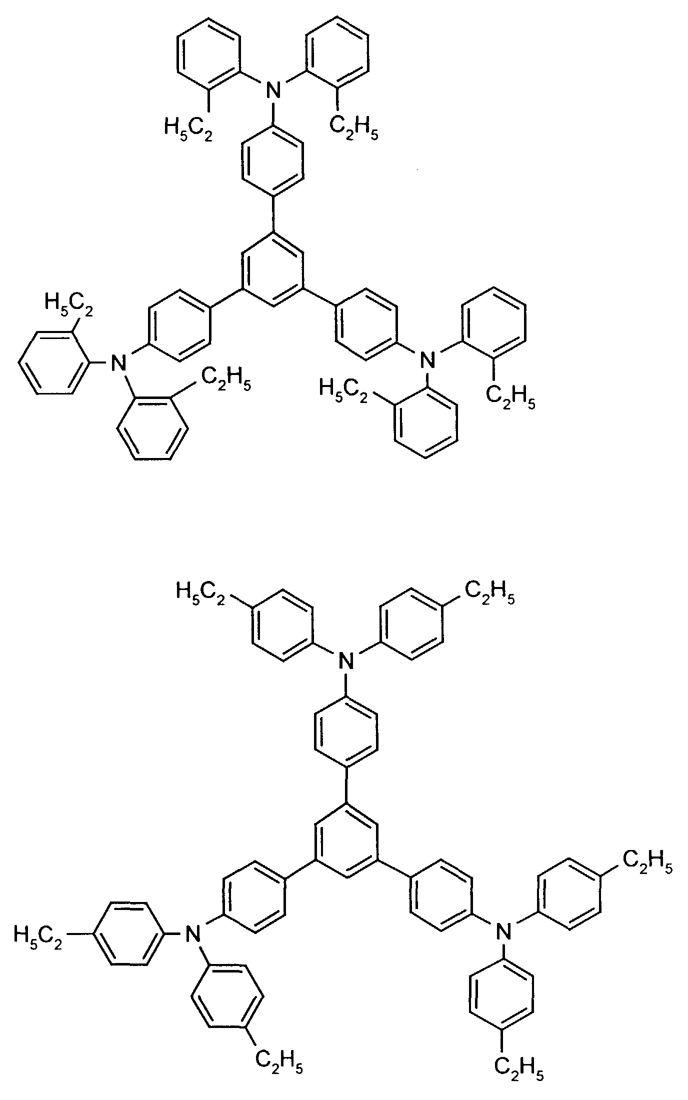

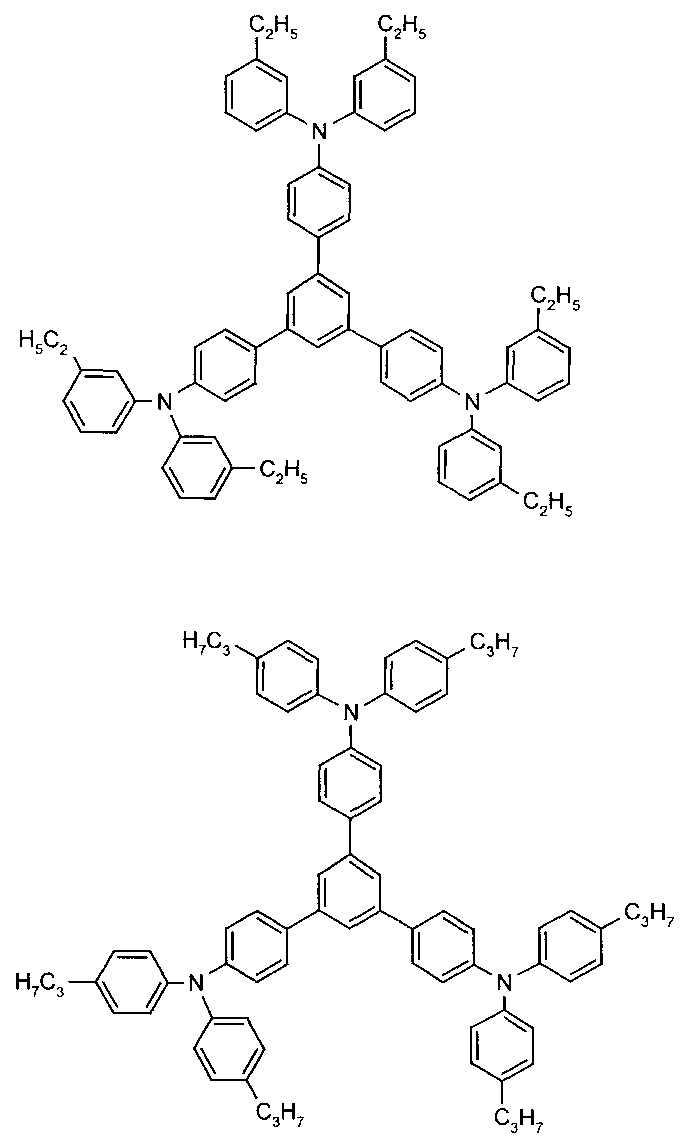

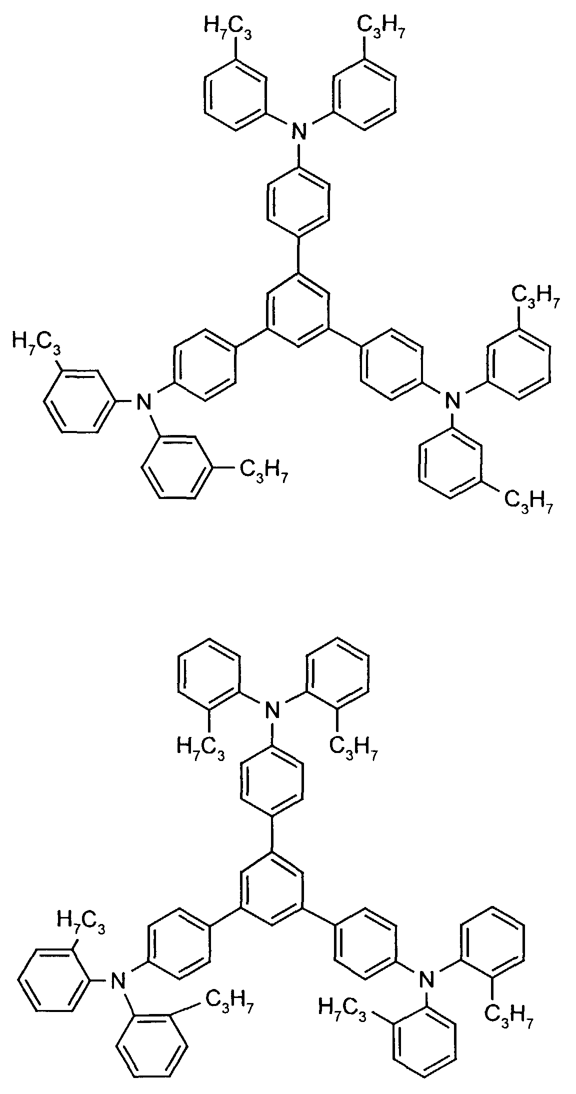

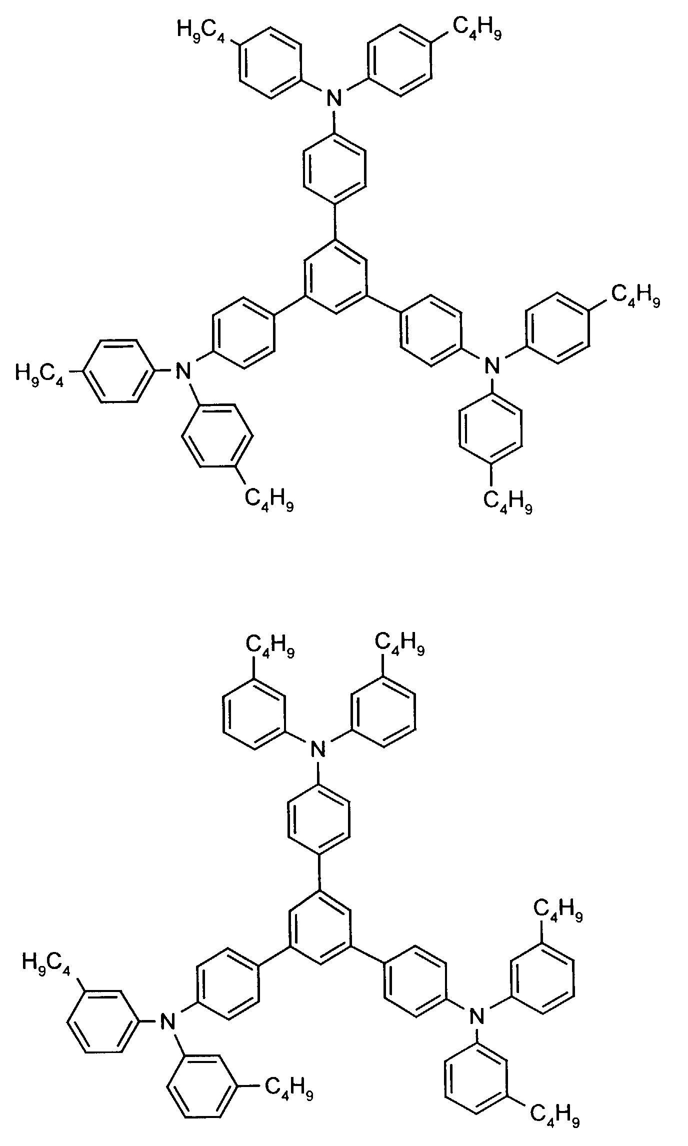

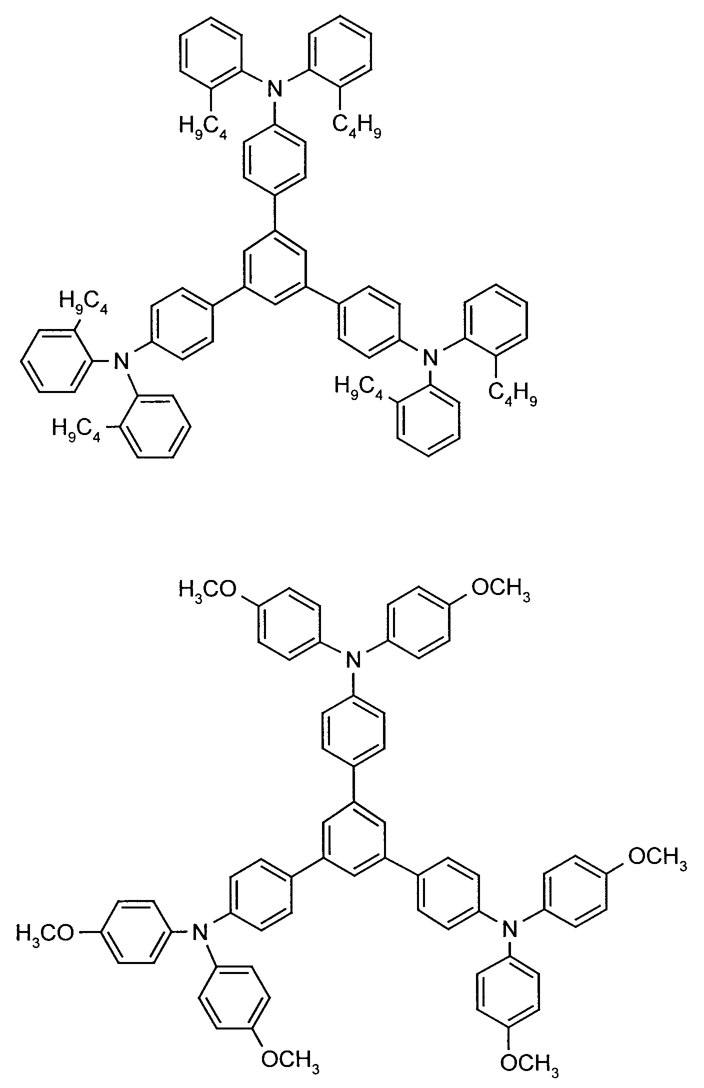

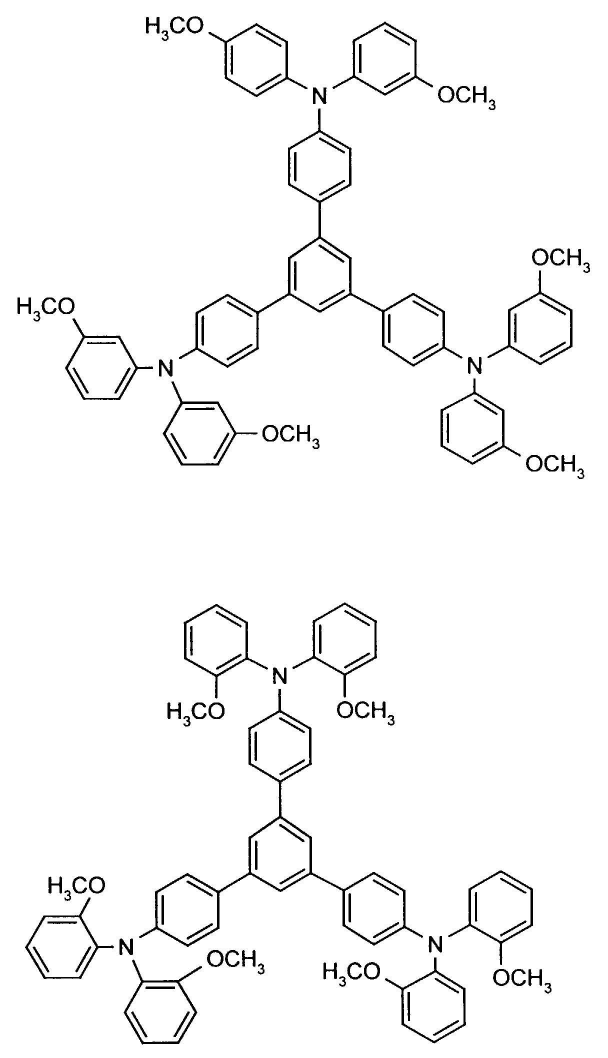

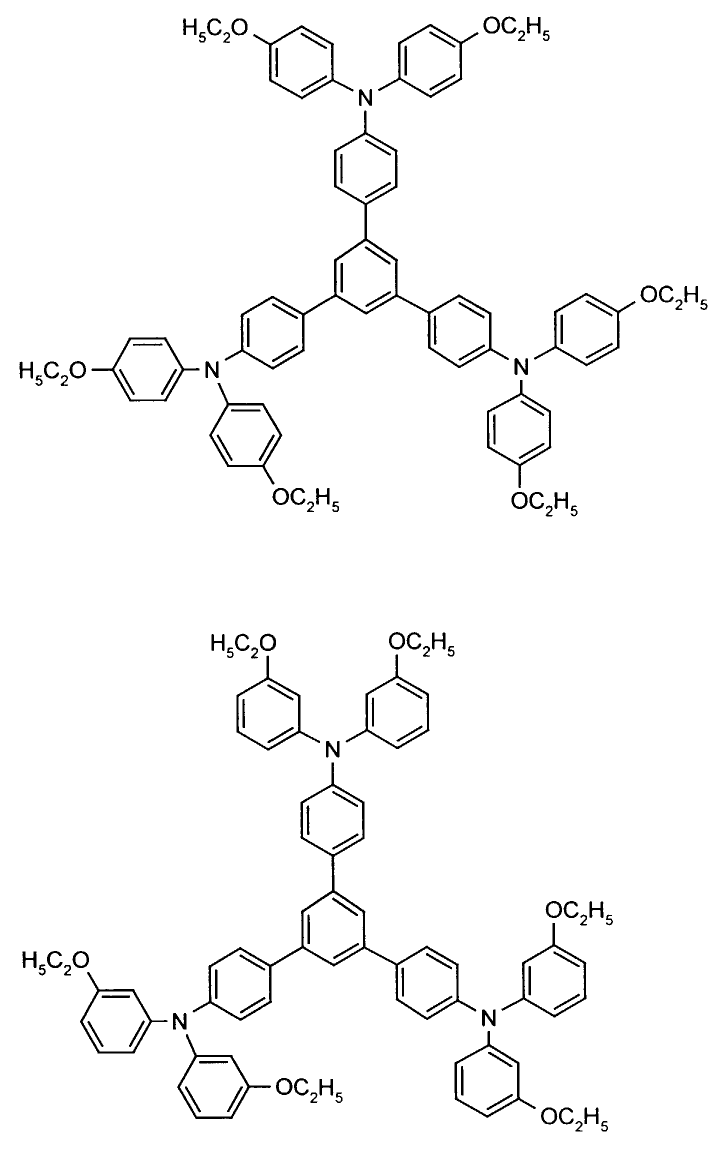

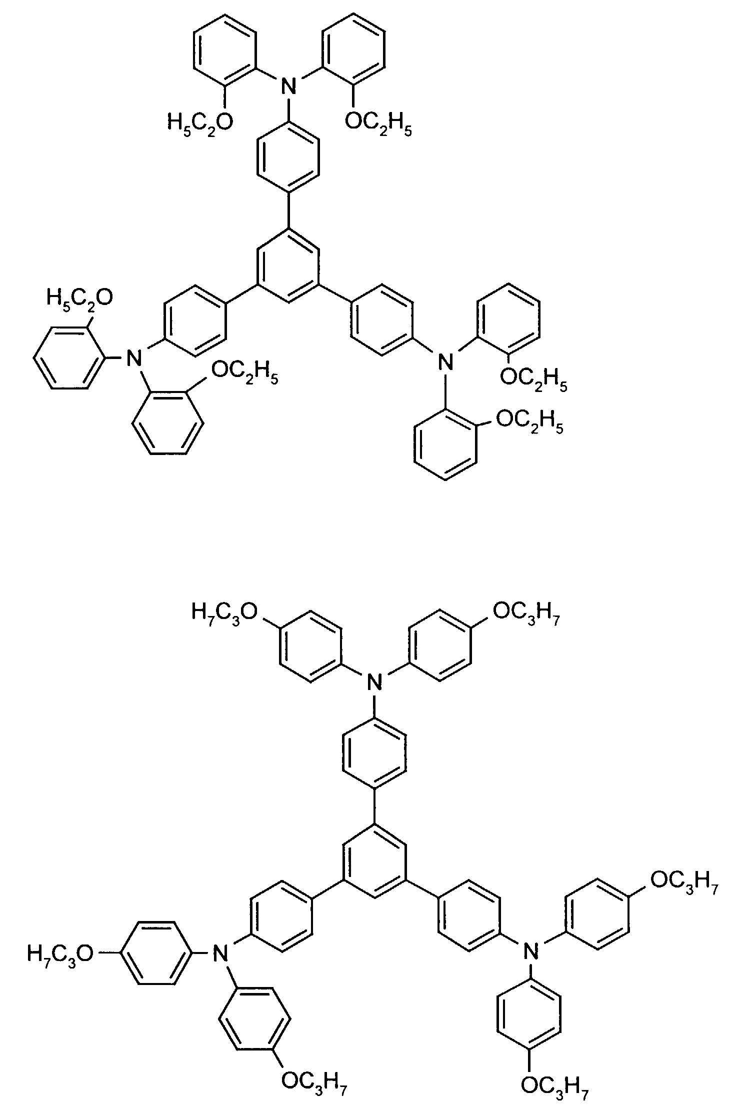

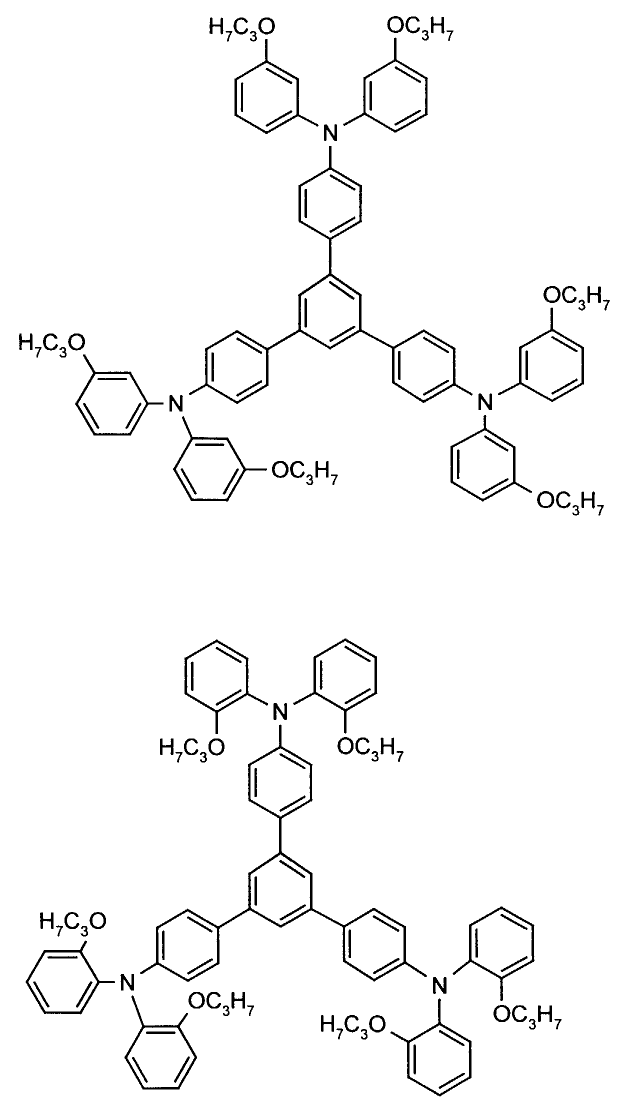

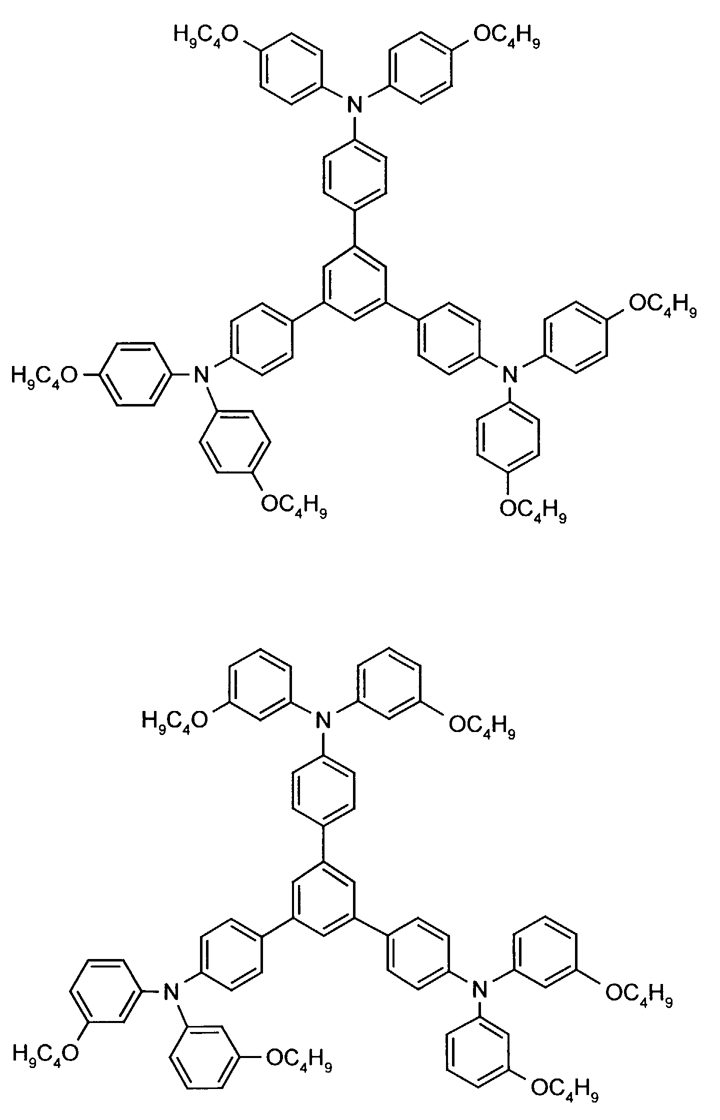

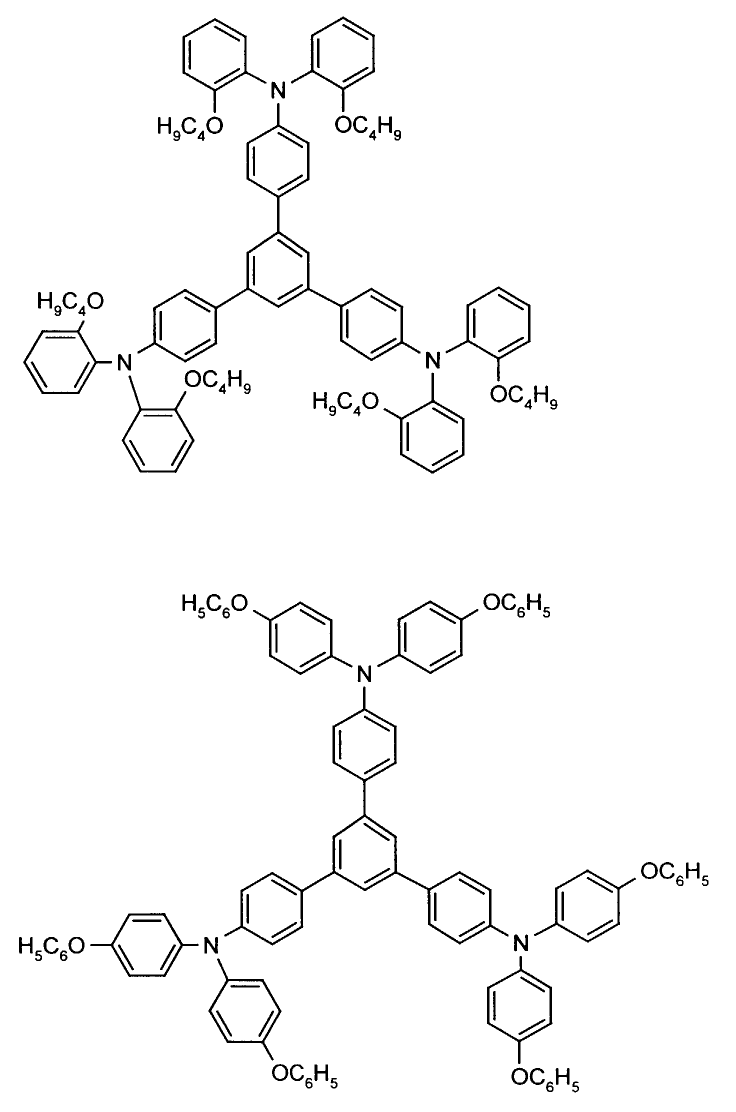

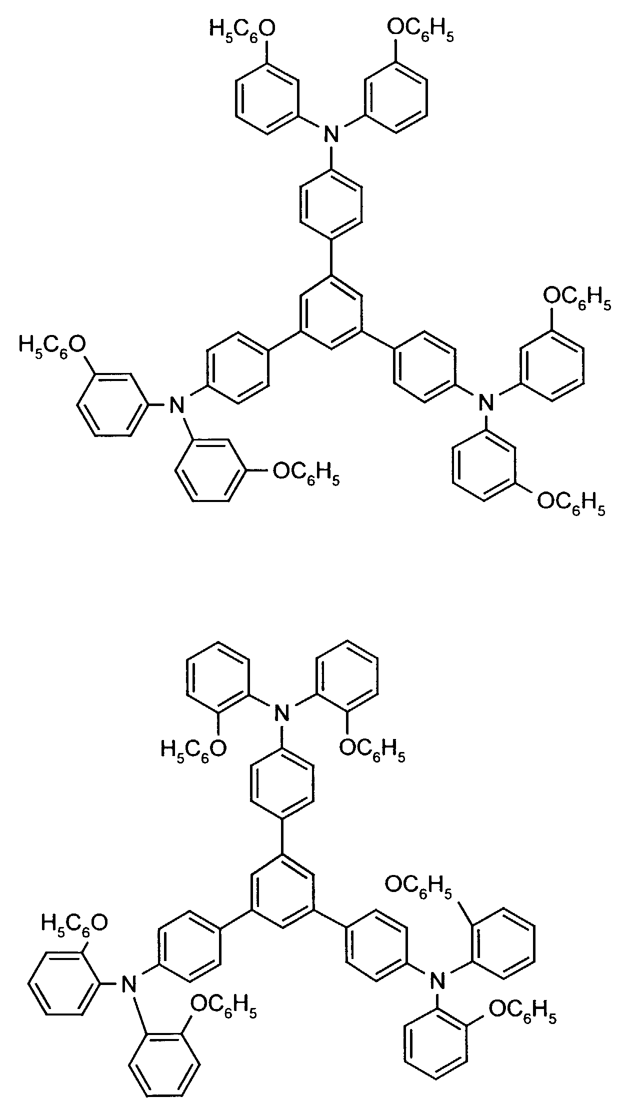

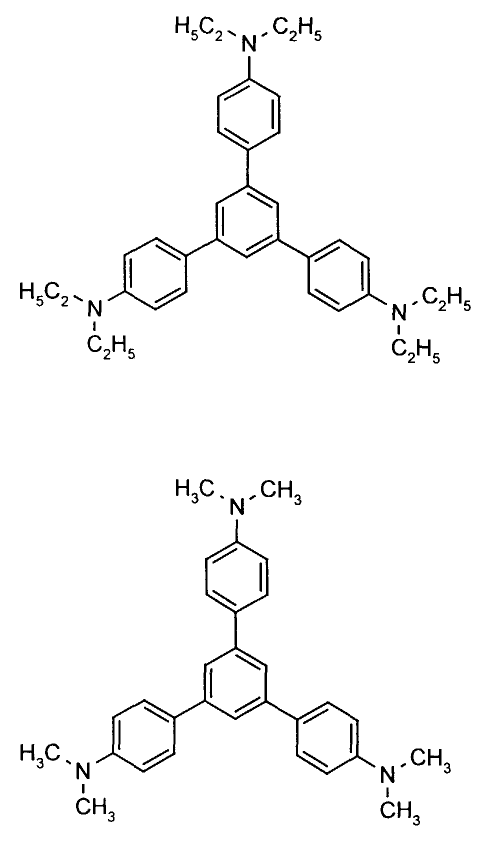

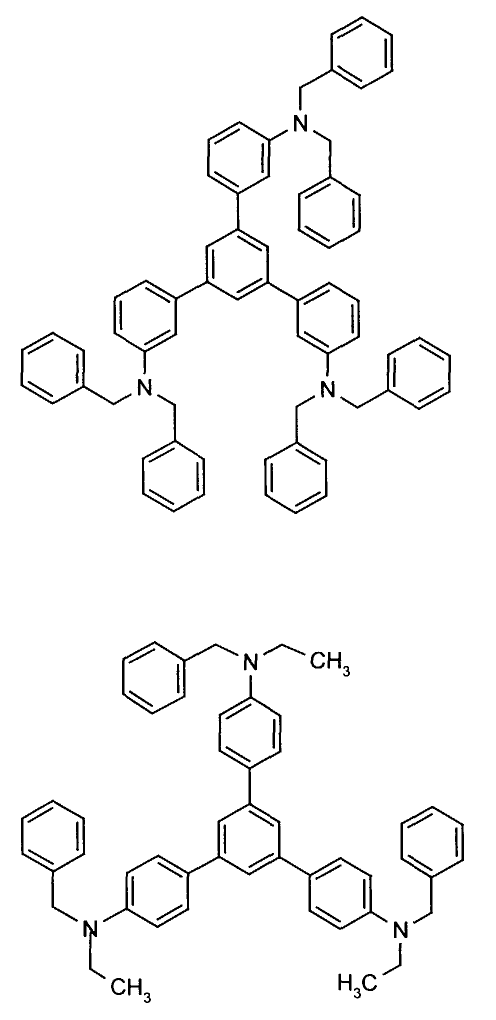

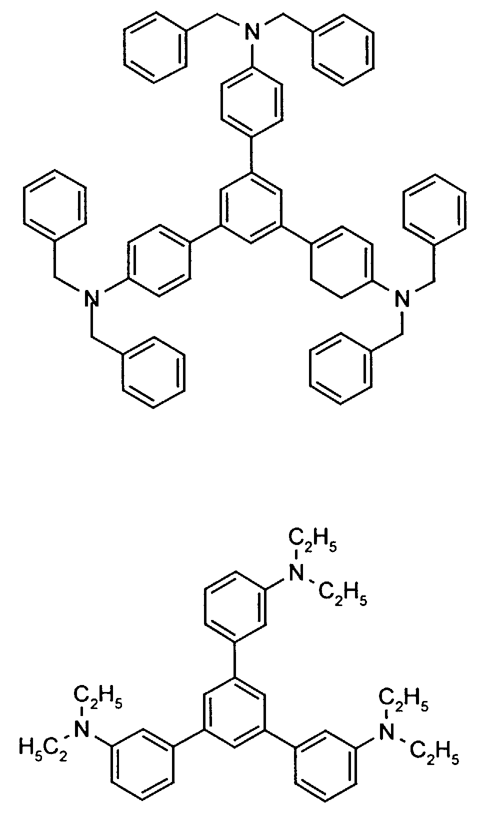

7. Elektrolumineszierende Anordnung gemäß Anspruch 1, dadurch gekennzeichnet, daß Komponente B) eine Verbindung der allgemeinen Formel (II) ist 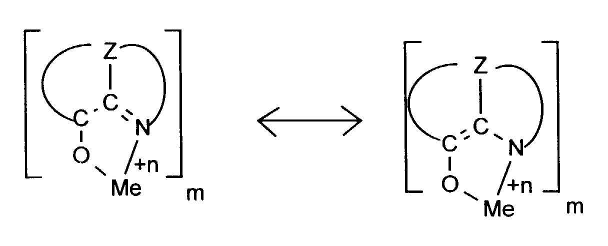 worin
Me für ein Metall steht,
m eine Zahl 1 bis 3 ist und
Z unabhängig in beiden Formen für Atome steht, die einen Kern vervollständigen, der wenigstens aus 2 kondensierten Ringen besteht.

8. Elektrolumineszierende Anordnung gemäß Anspruch 1, dadurch gekennzeichnet, daß die Chinacridon-Verbindung als Komponente C) ausgewählt ist aus folgenden Verbindungen:

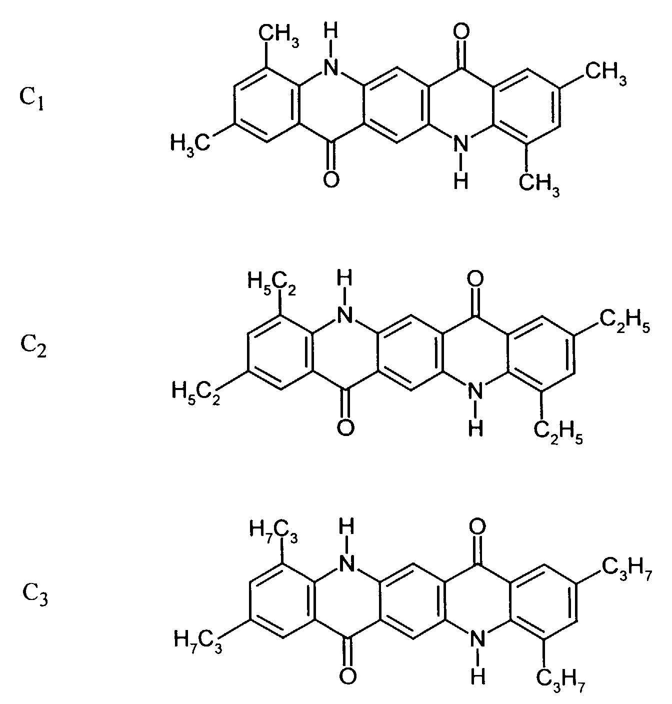

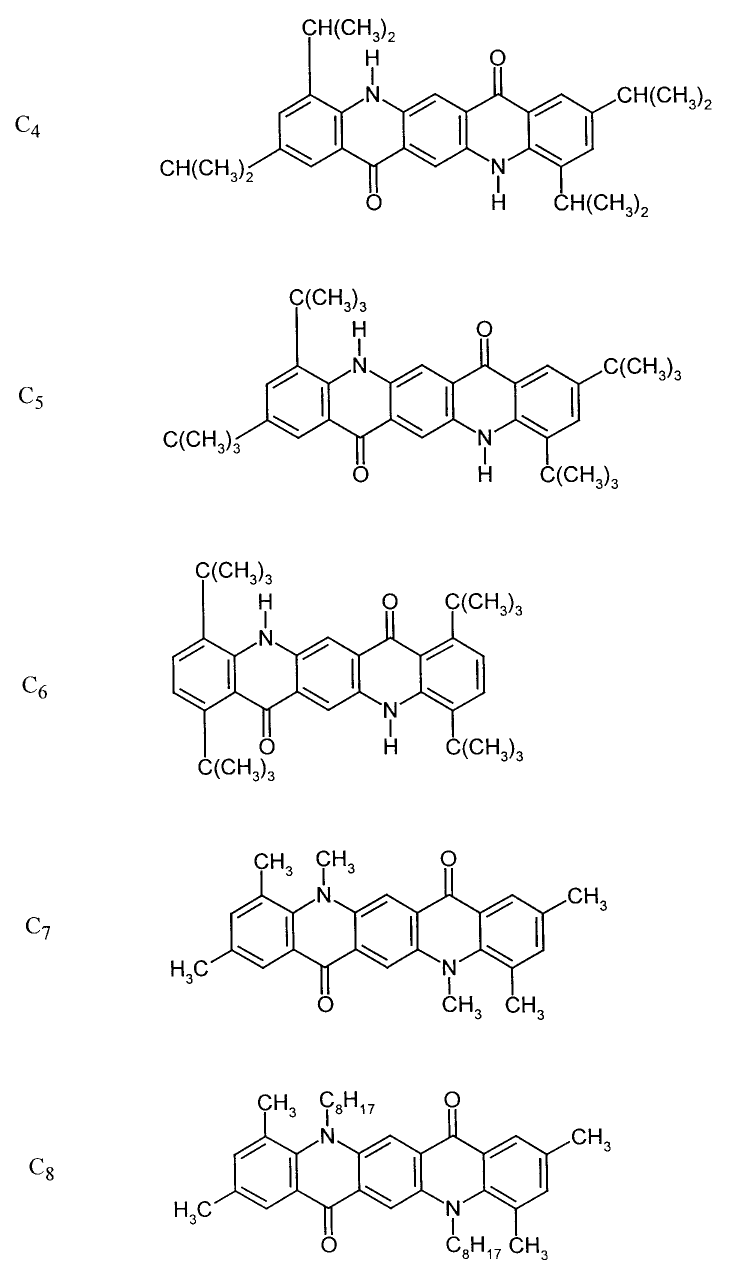

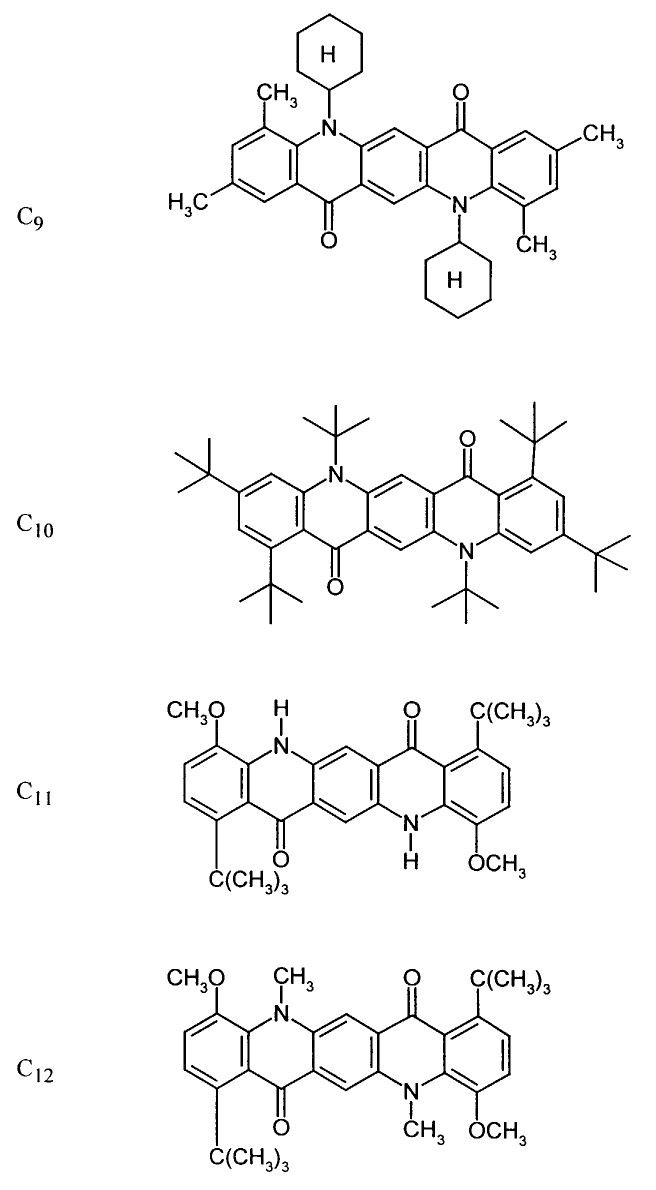

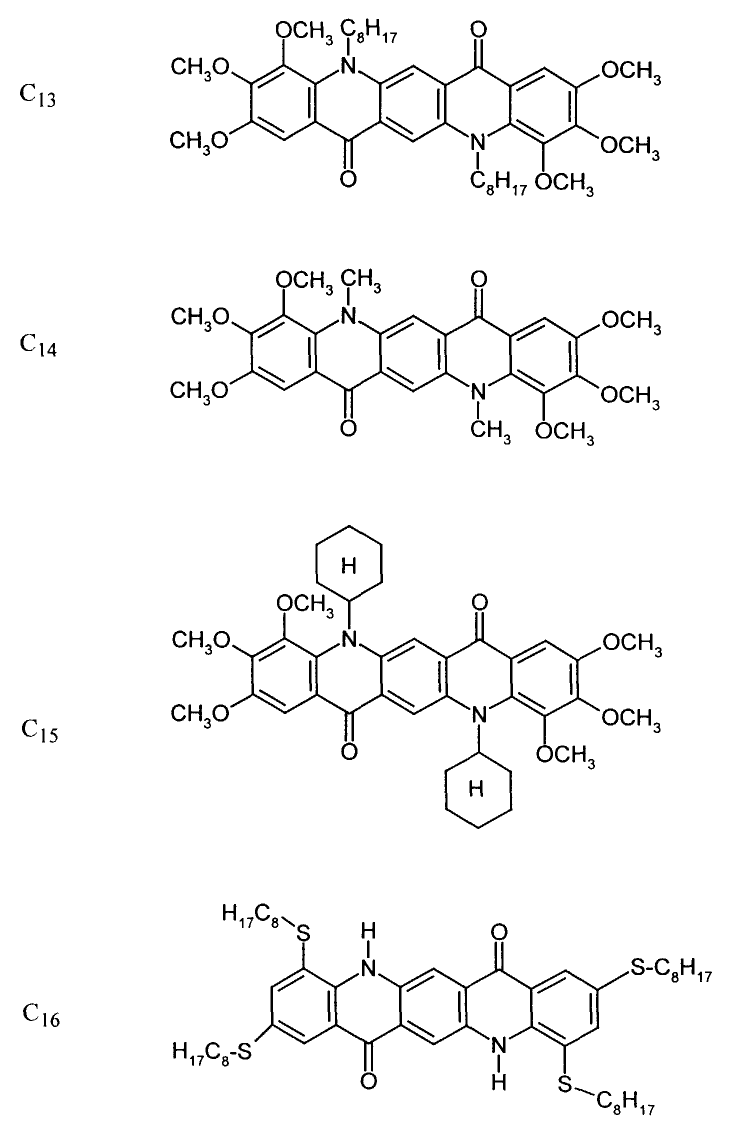

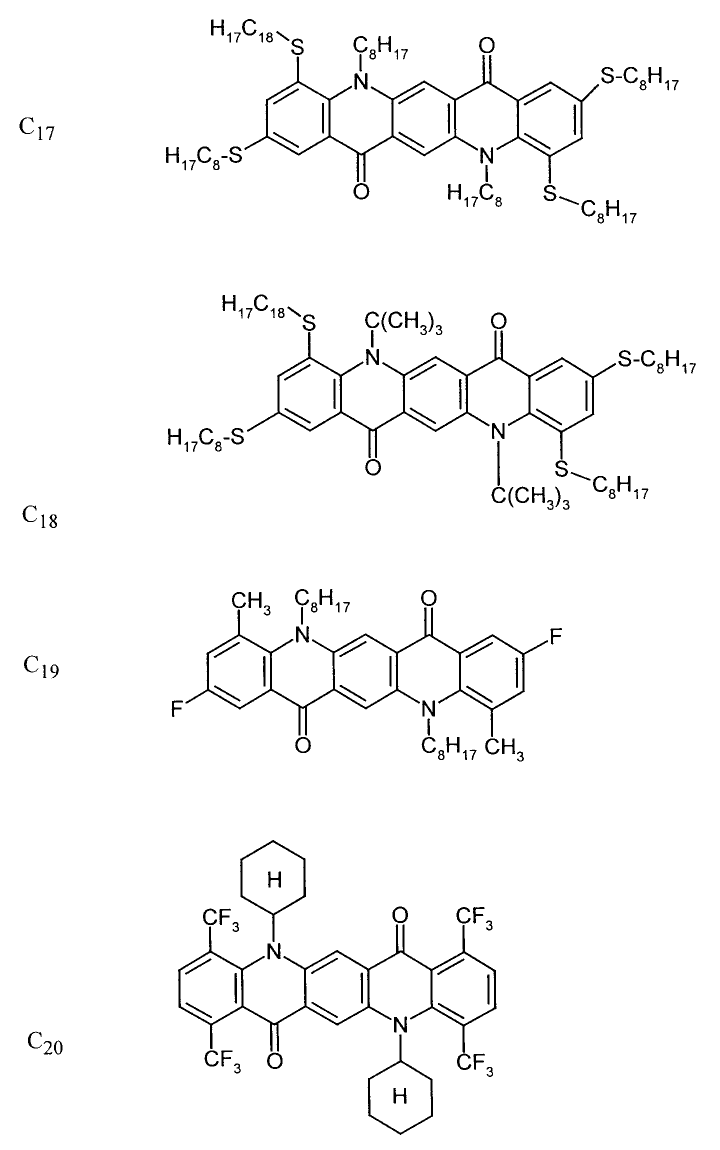

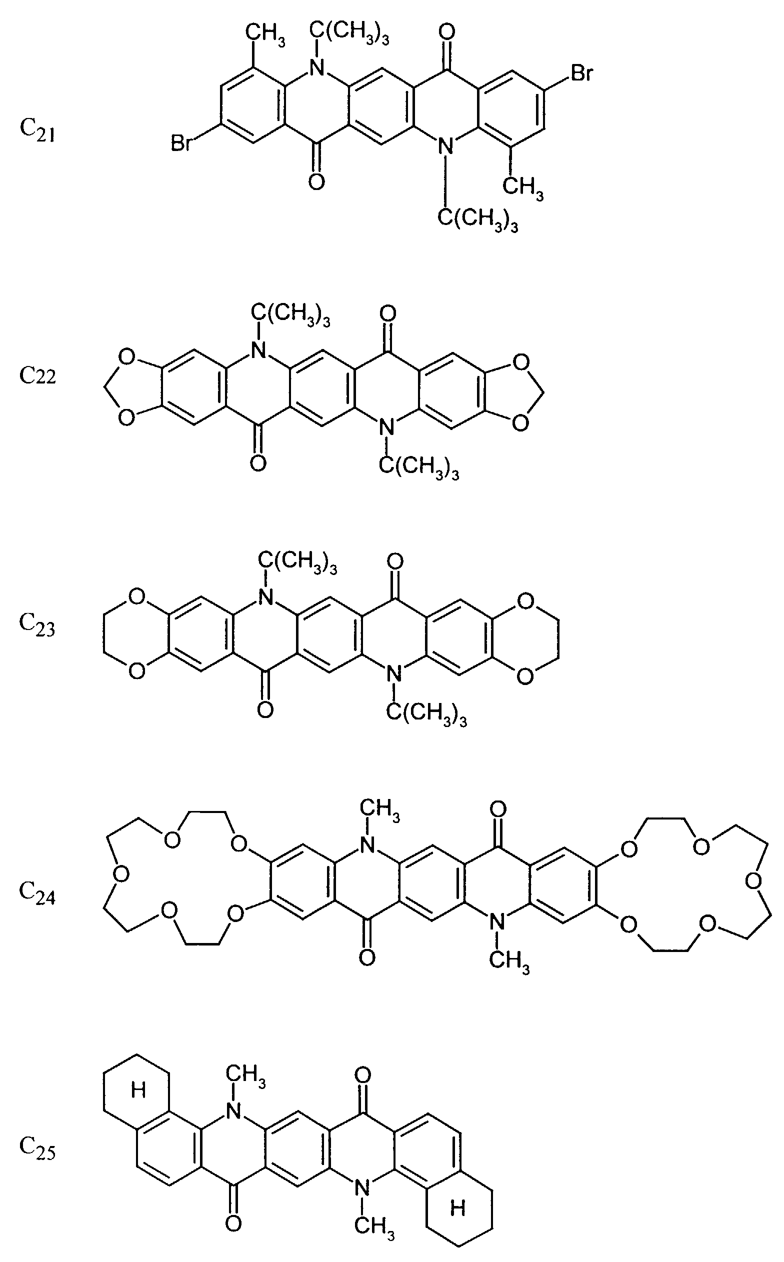

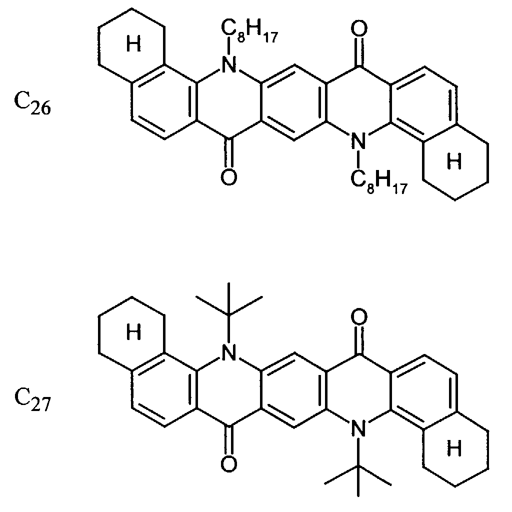

9. Elektrolumineszierende Anordnung gemäß Anspruch 7, dadurch gekennzeichnet, daß Me für ein-, zwei- oder dreiwertiges Metall steht, welches Chelate bildet.

10. Elektrolumineszierende Anordnung gemäß Anspruch 7, dadurch gekennzeichnet, daß Komponente B) ausgewählt ist aus Oxin-Komplexen (8-Hydroxychinolin-Komplexe) von Al³⁺, Mg²⁺, In³⁺, Li⁺, Ca²⁺, Na⁺ oder Aluminiumtris(5-methyloxin) und Galliumtris(5-chloro-chinolin) oder Seltenenerd-Metallkomplexen.

11. Elektrolumineszierende Anordnung gemäß Anspruch 3, dadurch gekennzeichnet, daß der transparente Binder ausgewählt ist aus der Gruppe Polycarbonate, Polyestercarbonate, Copolymere des Styrols oder Styrolacrylate, Polysulfone, Polymerisate auf Basis von Vinylgruppen-haltigen Monomeren, Polyolefine, cyclische Olelfincopolymere, Phenoxyharze.

12. Elektrolumineszierende Anordnung gemaß Anspruch 1, dadurch gekennzeichnet, daß der Gewichtsanteil der Summe der Gewichtsanteile von A) und B) im polymeren Binder im Bereich von 0,2 bis 98 Gew.-% liegt (bezogen auf 100 Gew.-% aus A + B + C) und das Gewichtsverhältnis A):B) der Komponenten A) und B) zwischen 0,05 und 20 liegt.

13. Elektrolumineszierende Anordnung gemäß Anspruch 1, dadurch gekennzeichnet, daß das elektrolumineszierende Element eine weitere ladungstransporierende Substanz aus der Gruppe der loch- und/oder elektronenleitenden Materialien enthält.

14. Elektrolumineszierende Anordnung gemäß Anspruch 1, dadurch gekennzeichnet, daß das elektrolumineszierende Element aus einem Einschichtsystem besteht.

15. Elektrolumineszierende Anordnung gemäß Anspruch 1, dadurch gekennzeichnet, daß das elektrolumineszierende Element aus einer Zone besteht, die eine gegebenenfalls substituierte Tris-1,3,5-(aminophenyl)benzolverbindung, 8-Hydroxychinolin-Aluminiumsalz (Aluminiumoxilat) und Polyvinylcarbazol enthält.

16. Verwendung der elektrolumineszierenden Anordnung gemäß Anspruch 1 zur Be-/Hinterleuchtung, Informationsdarstellung oder zum Aufbau von Segment- oder Matrixanzeigen.
